# EUROPEAN PATENT SPECIFICATION

(11) **EP 2 447 335 B1**
(45) Date of publication and mention of the grant of the patent: **11.11.2015**
(21) Application number: 10792366.6
(22) Date of filing: 25.06.2010
(51) Int. Cl.: C09K 11/06, H01L 51/50

(54) **COMPOUND FOR ORGANIC PHOTOELECTRIC DEVICE, ORGANIC LIGHT EMITTING DIODE INCLUDING THE SAME, AND DISPLAY INCLUDING THE ORGANIC LIGHT EMITTING DIODE**
VERBINDUNG FÜR EIN ORGANISCHES PHOTOELEKTRISCHES ELEMENT UND ORGANISCHES PHOTOELEKTRISCHES ELEMENT DAMIT
COMPOSÉ POUR ÉLÉMENT PHOTOÉLECTRIQUE ORGANIQUE, ET ÉLÉMENT PHOTOÉLECTRIQUE ORGANIQUE LE COMPRENANT

(30) Priority: 25.06.2009 KR 20090057236
(43) Date of publication of application: 02.05.2012
(73) Proprietor: CHEIL INDUSTRIES INC., Kumi-city Gyeongsangbuk-do 730-030 (KR)
(72) Inventor: JUNG, Sung-Hyun, Uiwang-si Gyeonggi-do 437-711 (KR); KIM, Young-Hoon, Uiwang-si Gyeonggi-do 437-711 (KR); KIM, Hyung-Sun, Uiwang-si Gyeonggi-do 437-711 (KR); LEE, Ho-Jae, Uiwang-si Gyeonggi-do 437-711 (KR); YU, Eun-Sun, Uiwang-si Gyeonggi-do 437-711 (KR); CHAE, Mi-Young, Uiwang-si Gyeonggi-do 437-711 (KR)
(74) Representative: Michalski Hüttermann & Partner Patentanwälte mbB
(86) International application number: PCT/KR2010/004157
(87) International publication number: WO 2010/151084

(56) References cited:
- EP-A1- 1 956 022
- WO-A1-2008/117826
- WO-A1-2008/146838
- WO-A1-2008/146839
- WO-A1-2009/031855
- KR-A- 20040 056 662
- KR-A- 20060 025 933
- US-A- 5 942 340
- US-A- 5 952 115
- US-A1- 2008 124 455

## Description

### [Technical Field]

This disclosure relates to a compound for an organic optoelectronic device, an organic light emitting diode including the same, and a display including the organic light emitting diode.

### [Background Art]

An organic optoelectronic device is, in a broad sense, a device for transforming photo-energy to electrical energy or a device for transforming electrical energy to photo-energy conversely. As examples, the organic optoelectronic device includes an organic light emitting diode (OLED), a solar cell, a transistor, and the like. Particularly, an organic light emitting diode has recently drawn attention due to the increase in demand for flat panel displays.

EP 1 956 022 A1 refers to an organic electroluminescent device (organic EL device) which is improved in luminous efficiency, fully secured of driving stability, and simple in constitution and a compound for use therein. The organic electroluminescent device comprises a light-emitting layer disposed between an anode and a cathode piled one upon another on a substrate and the light-emitting layer contains a phosphorescent dopant and a compound for use in an organic electroluminescent device having two or more indolocarbazole skeletons as a host material.

WO 2008/146839 A1 refers to an organic electroluminescent device (organic EL device) which is improved in luminous efficiency, fully secured of driving stability, and of simple constitution and a compound useful for the fabrication of said organic EL device. The compound for the organic EL device has an indolocarbazole structure or a structure similar thereto in the molecule wherein an aromatic group is bonded to the nitrogen atom in the indolocarbazole. The organic EL device has a light-emitting layer disposed between an anode and a cathode piled one upon another on a substrate and said light-emitting layer comprises a phosphorescent dopant and the aforementioned compound for an organic electroluminescent device as a host material.

WO 2008/117826 A1 refers to an organic electroluminescent device (organic EL device) which is improved in luminous efficiency, fully secured of driving stability, and of simple constitution. Also disclosed is a compound useful for the fabrication of said organic EL device. The organic electroluminescent device comprises organic layers including a light-emitting layer disposed between an anode and a cathode which are piled one upon another on a substrate and at least one of said organic layers comprises a compound for an organic EL device. Said organic layer is preferably a light-emitting layer containing a phosphorescent dopant.

WO 2009/031855 A1 refers to a phosphorescent light emitting material for an organic photoelectric device having thermal stability due to a glass transition temperature (T9) of 120° C or more and a thermal decomposition temperature (Td) of 400° C or more, and being capable of realizing a high efficiency organic photoelectric device. The material may be used singularly or as a host material in combination with a dopant, and includes a symmetric or asymmetric bipolar organic compound including both a hole transporting unit and an electron transporting unit. An organic photoelectric device including the material can also be provided. The material for an organic photoelectric device can provide an organic photoelectric device having high luminous efficiency at a low driving voltage.

WO 2008/146838 A1 refers to an organic electroluminescent device having high external quantum efficiency and long emission life. Also disclosed are an illuminating device and a display device, each comprising such an organic electroluminescent device. Specifically disclosed is an organic electroluminescent device comprising at least an anode and a cathode arranged on a supporting substrate and at least two organic layers, namely a first organic layer and a second organic layer, between the anode and the cathode. This organic electroluminescent device is characterized in that the first organic layer contains a light-emitting dopant and the second organic layer contains a charge-transporting material and a part of the material constituting the first organic layer. The organic electroluminescent device is further characterized in that the second organic layer is formed by coating after formation of the first organic layer.

When current is applied to an organic light emitting diode, holes are injected from an anode and electrons are injected from a cathode, then injected holes and electrons move to each hole transport layer (HTL) and electron transport layer (ETL) and recombined to a light emitting exciton in an emission layer. The light emitting excitons generate lights while shifting to a ground state. The light emission material may be classified as a fluorescent material including singlet excitons and a phosphorescent material including triplet excitons according to light emitting mechanism. The fluorescent and phosphorescent materials may be used for a light emitting source of an organic light emitting diode (D. F.O'Brien, Appl. Phys. Lett., 74 3, 442, 1999; M. A. Baldo, Appl. Phys. lett., 75 1, 4, 1999).

When electrons are transported from the ground state to the exited state, a single exciton undergoes non-light emitting transition to a triplet exciton through intersystem crossing and the triplet exciton is transited to the ground state to emit light. Herein, such a light emission refers to phosphorescent emission. When the triplet exciton is transited, it cannot directly transit to the ground state. Therefore, it is transited to the ground state after the electron spin is flipped.

Therefore, a half-life (light emitting time, lifetime) of phosphorescent emission is longer than that of fluorescent emission.

When holes and electrons are recombined to produce a light emitting exciton, three times triplet light emitting excitons are produced compared to the amount of the singlet light emitting excitons. A fluorescent material has 25% of the singlet-exited state and a limit in luminous efficiency. On the other hand, a phosphorescent material can utilize 75% of the triplet exited state and 25% of the singlet exited state, so it can theoretically reach 100% of the internal quantum efficiency. Accordingly, the phosphorescent light emitting material has advantages of accomplishing around four times more luminous efficiency than the fluorescent light emitting material.

Meanwhile, a dopant along with the host material may be included in an emission layer to increase efficiency and stability of organic light emitting diode. For the host material, 4-N,N-dicarbazolebiphenyl (CBP) has been mainly used. However, CBP has high structural symmetry and may be easily crystallized. Due to low thermal stability, short-circuit or a pixel defect may occur during heat resistance test of a device. Furthermore, since host materials such as CBP has faster hole transport speed than electron transport speed, an exciton may not be effectively formed in an emission layer, decreasing luminous efficiency of a device.

In addition, a low molecular host material is in general using a vacuum-deposition, the vacuum deposition may cost more than a wet process. In addition, most of low molecular host materials have low solubility against an organic solvent, they may not be applied in a wet process and thus, form an organic thin layer having excellent film characteristics.

Accordingly, in order to realize an organic optoelectronic device with excellent efficiency and life-span, there are needs for development of a phosphorescent host material and a charge transport material having excellent electrical and thermal stability and bipolar characteristics well-transporting both holes and electrons or a host material mixed with a material being capable of transporting holes and electrons well.

### [DISCLOSURE]

### [Technical Problem]

One embodiment of the present invention provides a compound for an organic optoelectronic device having excellent thermal stability, and being capable of transporting holes and electrons well.

Another embodiment of the present invention provides an organic light emitting diode having excellent efficiency and a driving voltage by including the compound for an organic optoelectronic device.

Yet another embodiment of the present invention provides a display device including the organic light emitting diode.

### [Technical Solution]

According to the present invention, a compound for an organic photoelectric device comprising substituents represented by the following Chemical Formulas 1aand2: 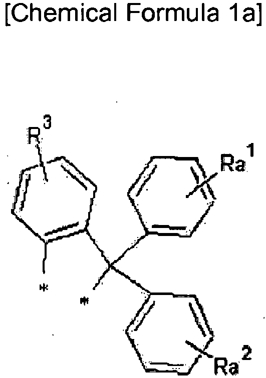 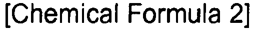 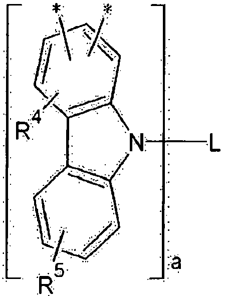 wherein, in Chemical Formulas 1 a and 2,
L is a divalent linking group that is a substituted or unsubstituted C2 to C30 heteroarylene group,
Ra¹ and Ra² are the same or different, and are each independently hydrogen or a C1 to C10 alkyl group, and
R³ is hydrogen, a carbazolyl group, a C1 to C30 alkyl group, a C6 to C30 aryl group, a C2 to C30 heteroaryl group, a C6 to C30 arylamine group, or a combination thereof,
R⁴ and R⁵ are the same or different and are each independently hydrogen, a carbazolyl group, a C1 to C30 alkyl group, a C6 to C30 aryl group, a C2 to C30 heteroaryl group, a C6 to C30 arylamine group, or a combination thereof, and
a is an integer of 2.

The above Chemical Formula 1 may be represented by the following Chemical Formula 1a. 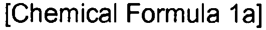 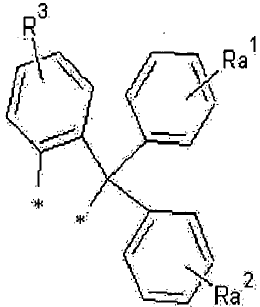 In Chemical Formula 1a
Ra¹ and Ra² are the same or different, and are each independently hydrogen or a C1 to C10 alkyl group, and
R³ is hydrogen, a carbazolyl group, a C1 to C30 alkyl group, a C6 to C30 aryl group, a C2 to C30 heteroaryl group, a C6 to C30 arylamine group, or a combination thereof.

The above Chemical Formula 2 may be represented by one of the following Chemical Formulas 2a to 2c. 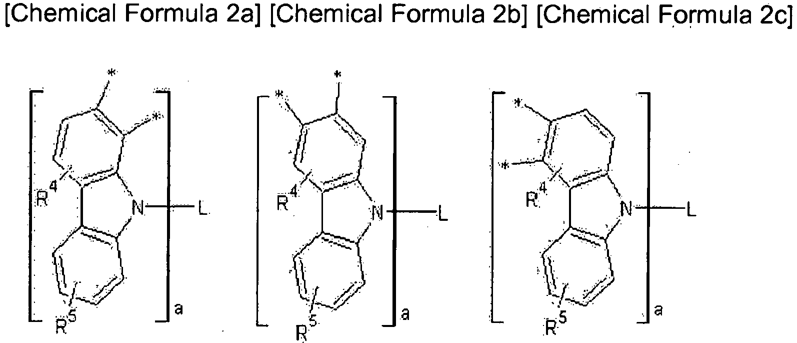 In Chemical Formulas 2a to 2c,
L is a divalent to heptavalent linking group that is an oxide group, an amine group, a phosphonyl group, a phsophonate group, a sulfonyl group, a sulfonate group, a substituted or unsubstituted C1 to C30 alkylene group, a substituted or unsubstituted C1 to C30 heteroalkylene group, a substituted or unsubstituted C3 to C30 cycloalkylene group, a substituted or unsubstituted C1 to C30 heterocycloalkylene group, a substituted or unsubstituted C6 to C30 arylene group, a substituted or unsubstituted C2 to C30 heteroarylene group, or a combination thereof,
R⁴ and R⁵ are the same or different and are each independently hydrogen, a carbazolyl group, a C1 to C30 alkyl group, a C6 to C30 aryl group, a C2 to C30 heteroaryl group, a C6 to C30 arylamine group, or a combination thereof, and
a is an integer ranging from 2 to 5.

The L of the above Chemical Formula 2 may be a divalent to heptavalent linking group derived from compounds represented by the following Chemical Formulas 2d to 2j or a combination thereof. 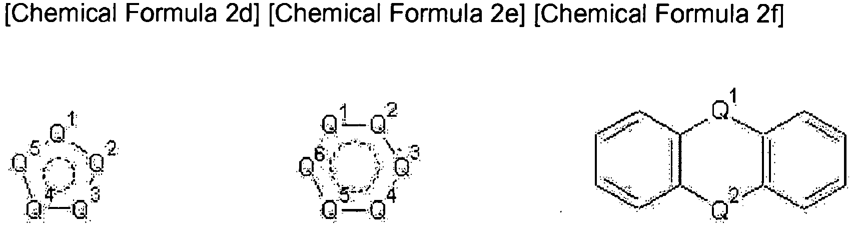 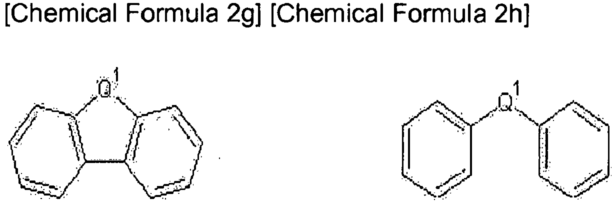 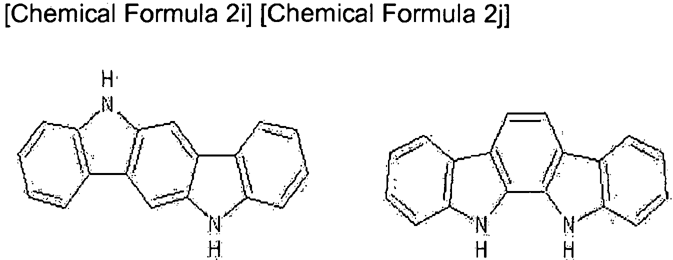 In Chemical Formulas 2d to 2j
Q¹ to Q⁶ are the same or different, and are each independently a substituted or unsubstituted N atom, a substituted or unsubstituted P atom, a substituted or unsubstituted S atom, a substituted or unsubstituted O atom, a substituted or unsubstituted C atom, or a combination thereof, wherein the substituted refers to one substituted with hydrogen, an oxide group, a cyano group, a halogen group, a C1 to C30 alkyl group, a C6 to C30 aryl group, a C2 to C30 heteroaryl group, or a combination thereof.
In Chemical Formula 2, a may be 2 or 3.
L of the above Chemical Formula 2 may be represented by the following Chemical Formula 2k.

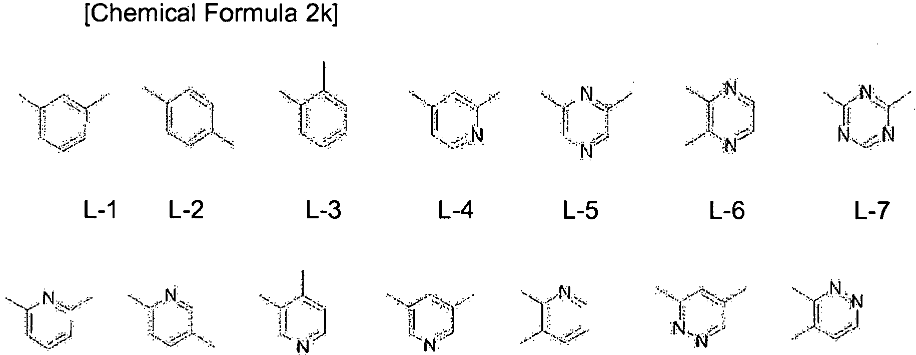

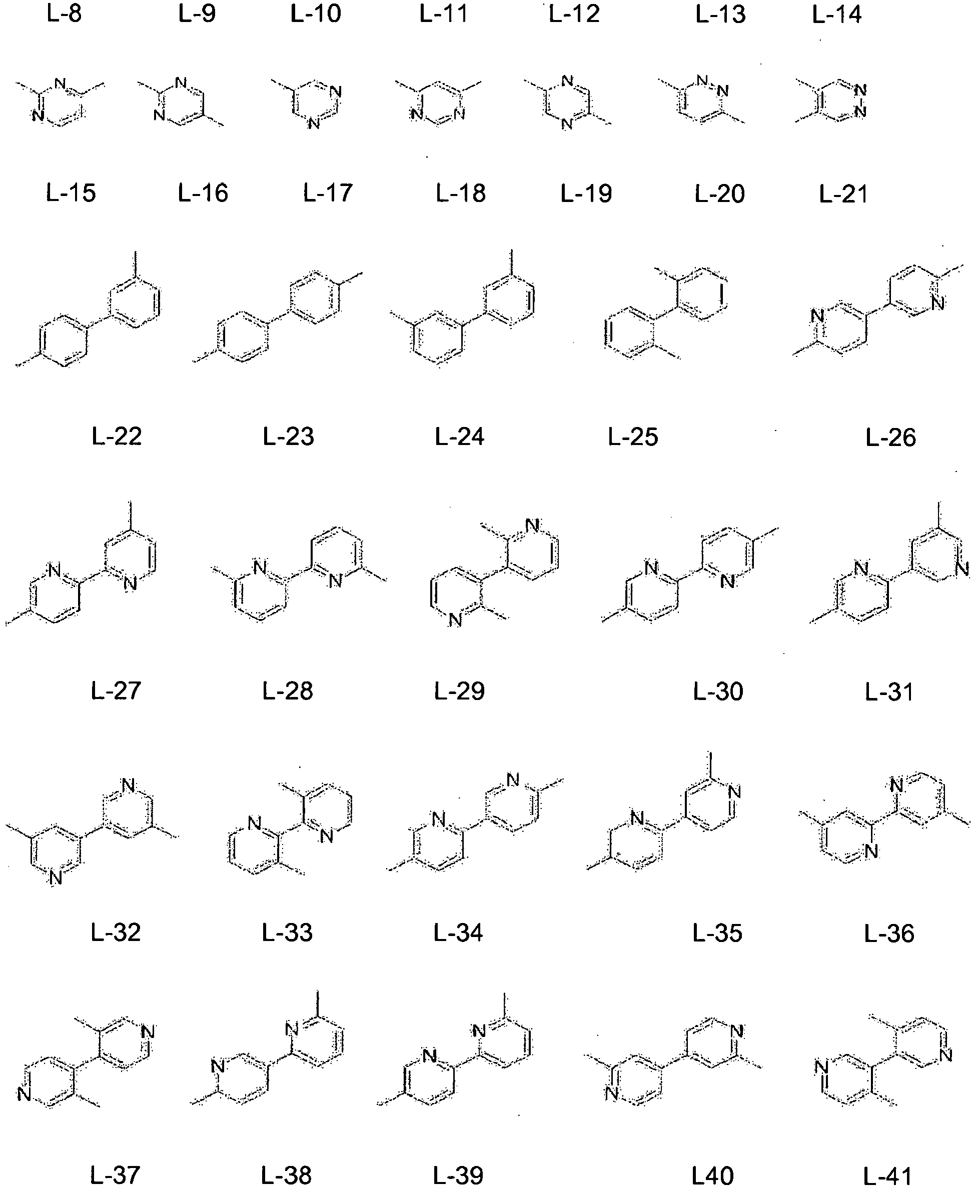

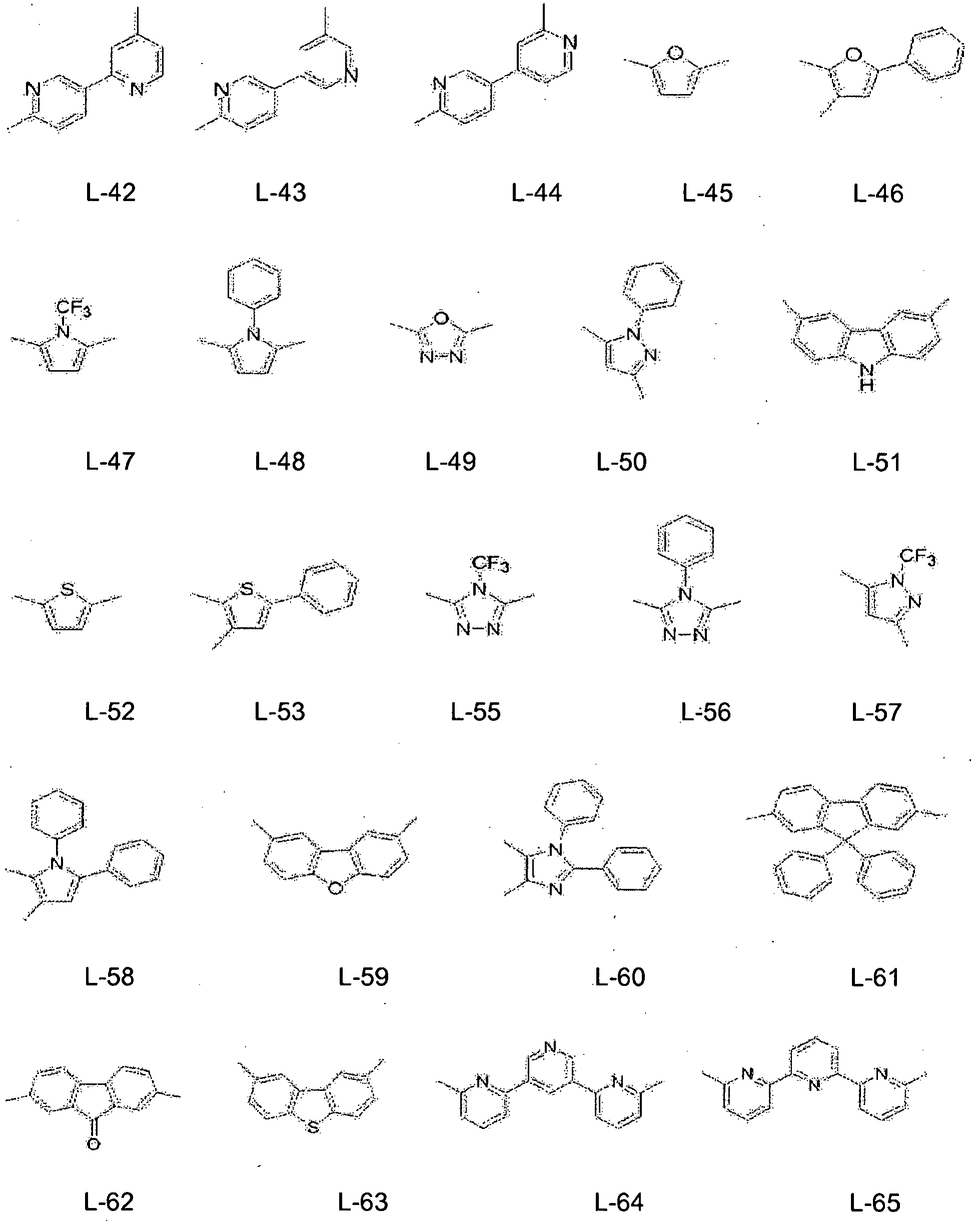

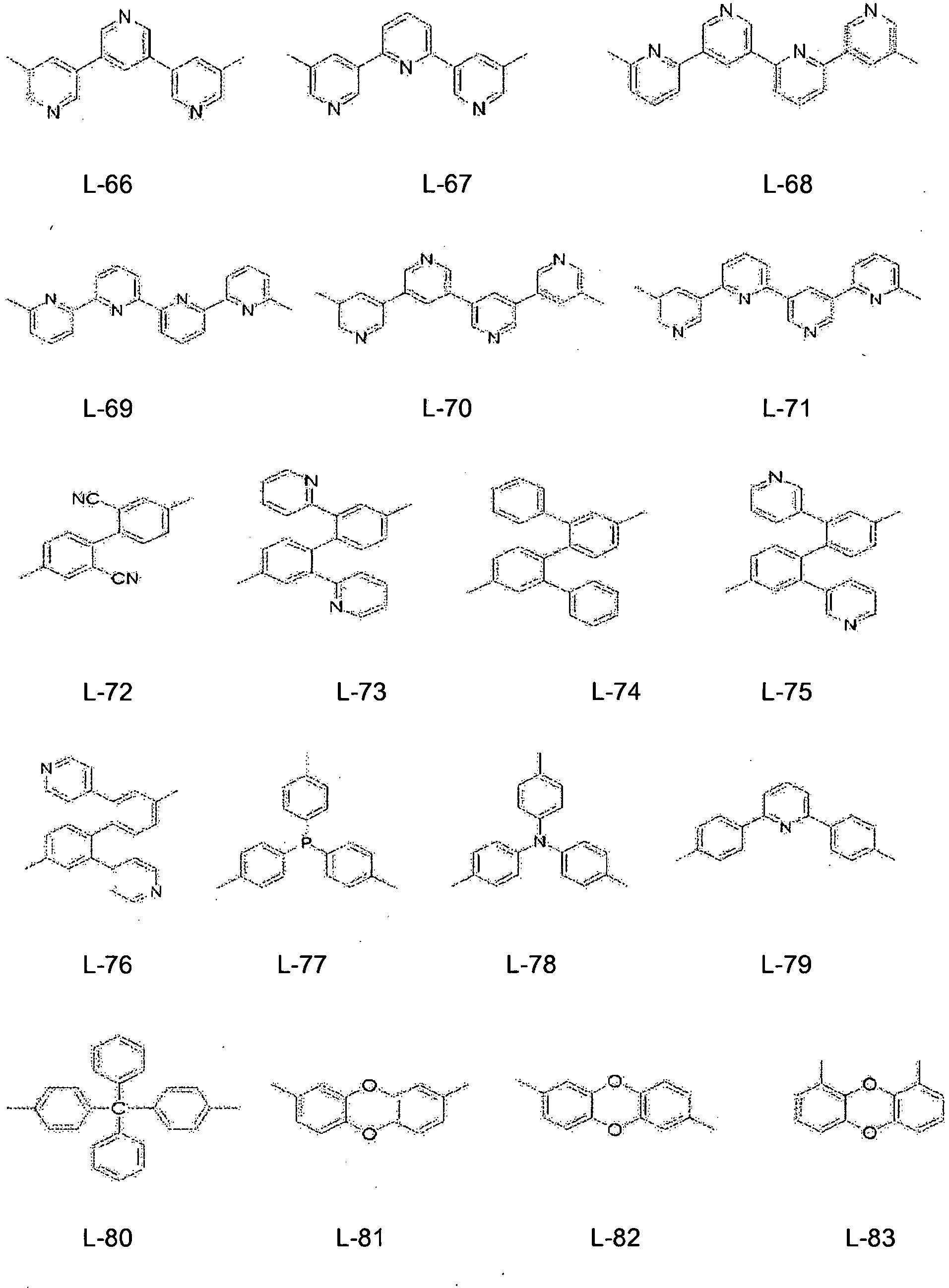

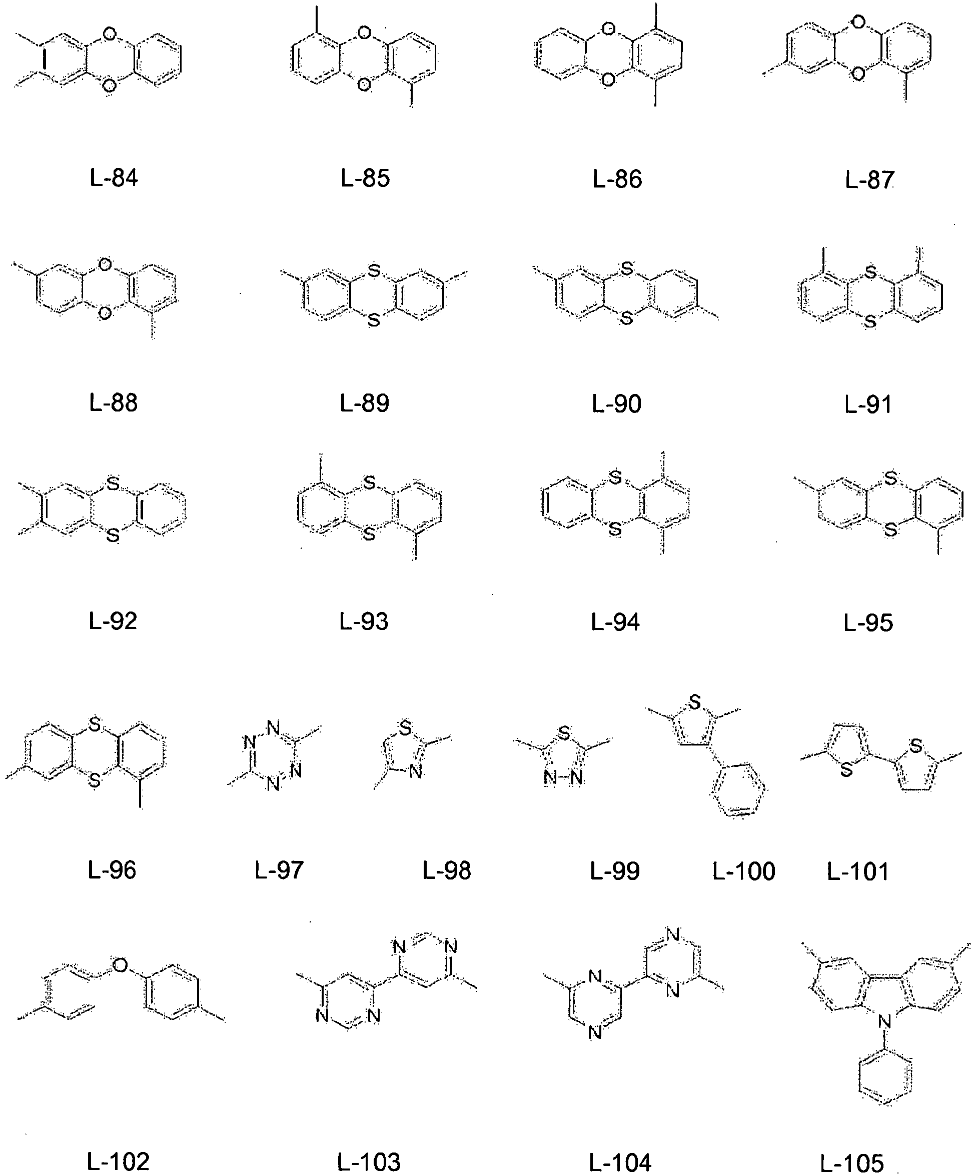

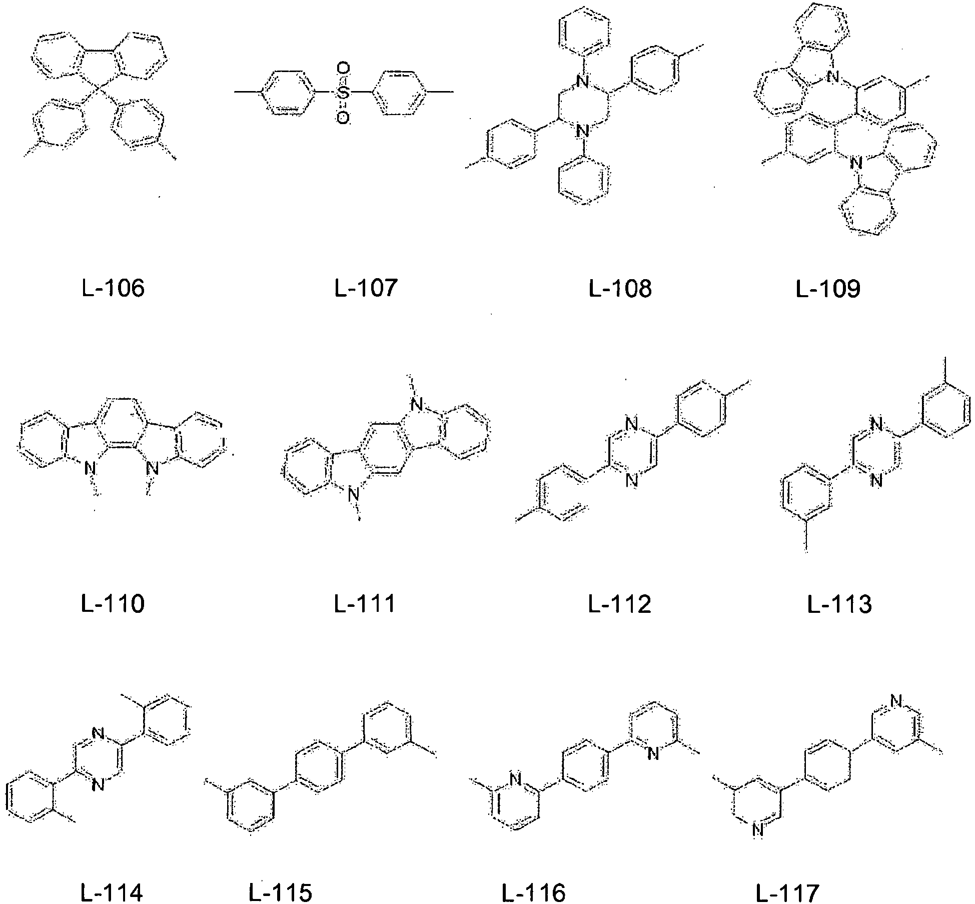

The compound for an organic optoelectronic device may be represented by the following Chemical Formulas 3 to 8.

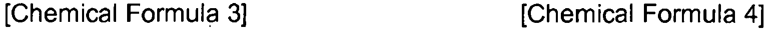

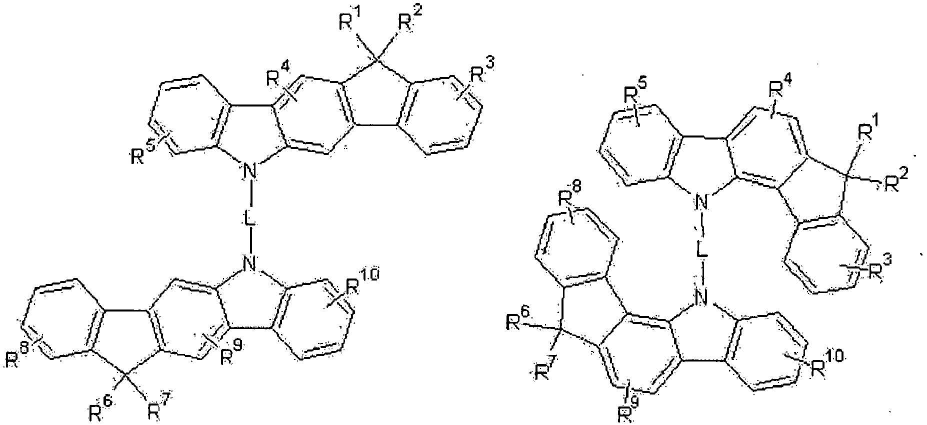

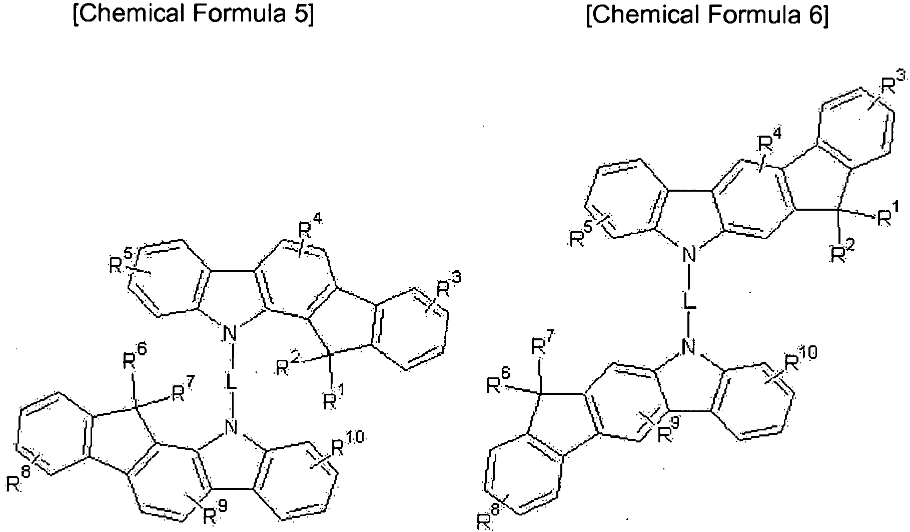

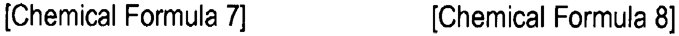

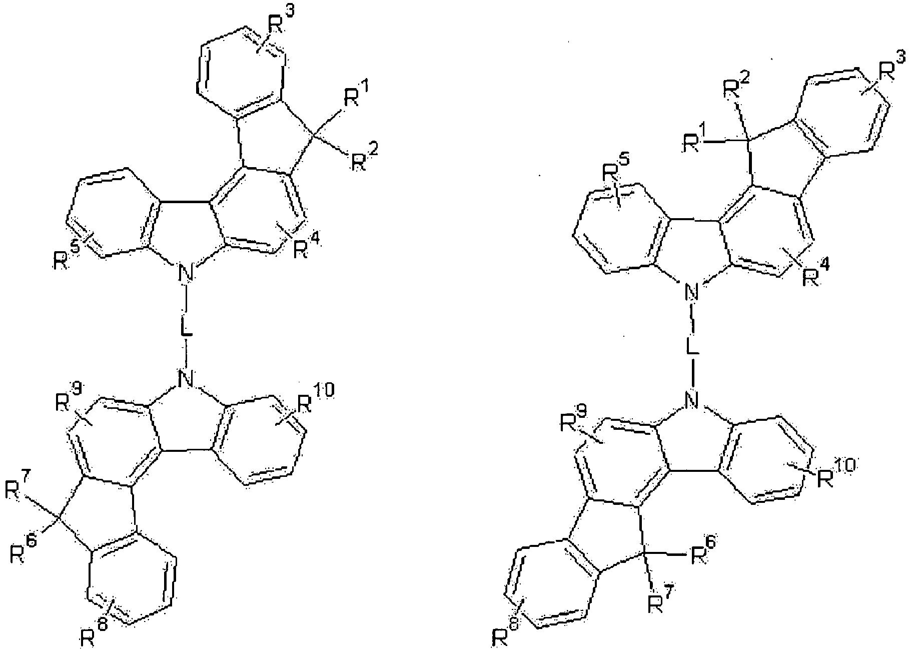

In Chemical Formulas 3 to 8,
L is a divalent linking group that is a substituted or unsubstituted C2 to C30 heteroarylene group
R¹, R⁶ are phenyl-Ra¹,
R², R⁷ are phenyl-Ra², and
R³ to R⁵, and R⁸ to R¹⁰ are the same or different, and are each independently hydrogen, a carbazolyl group, a C1 to C30 alkyl group, a C6 to C30 aryl group, a C2 to C30 heteroaryl group, a C6 to C30 arylamine group, or a combination thereof.

The compound for an organic optoelectronic device may be represented by the following Chemical Formulas 9 to 33.

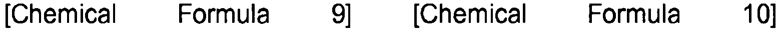

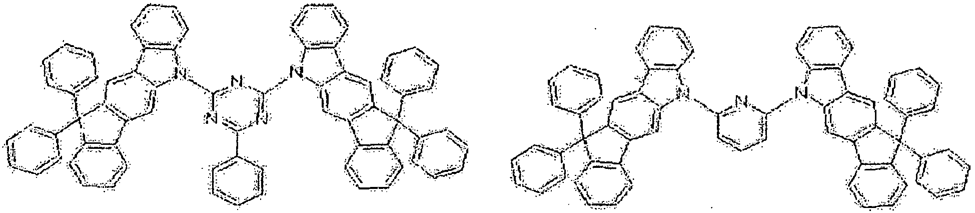

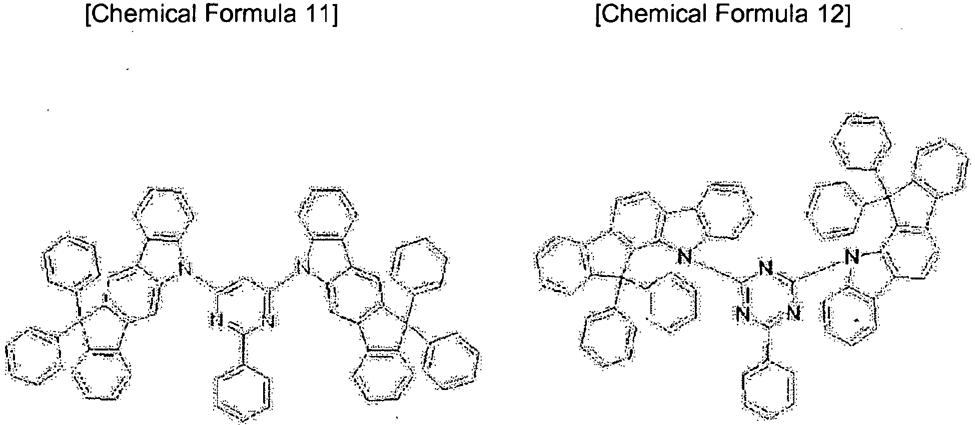

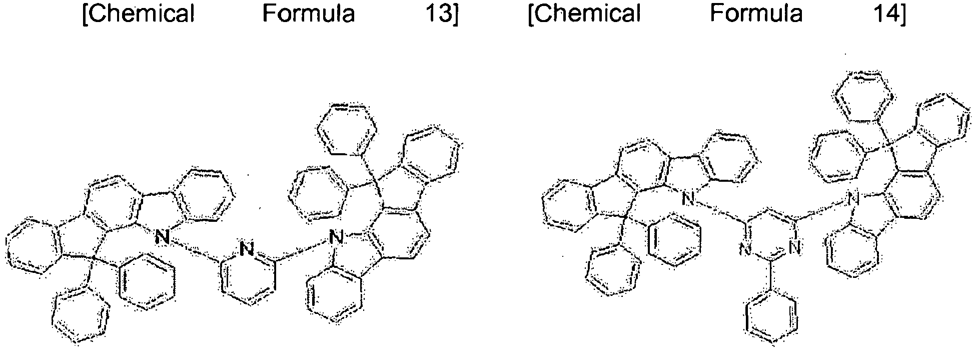

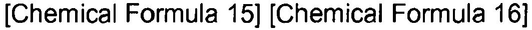

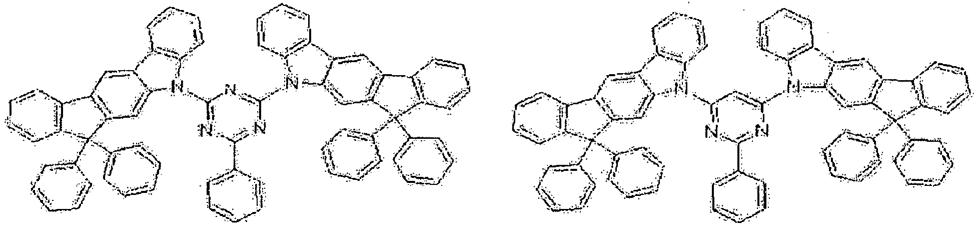

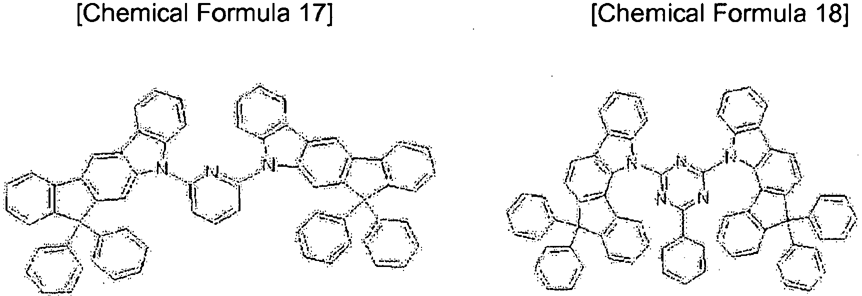

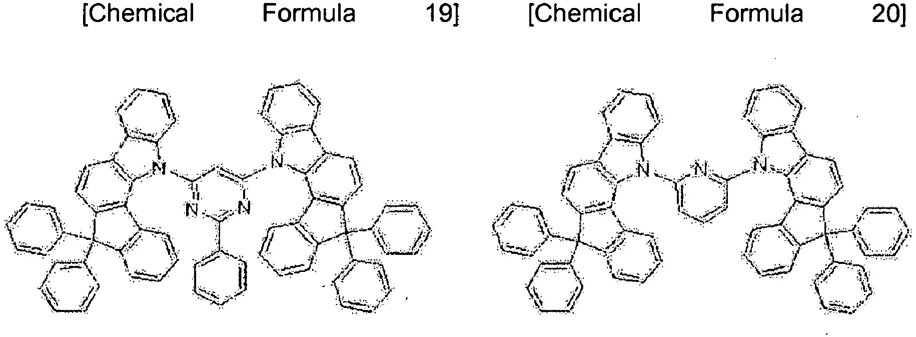

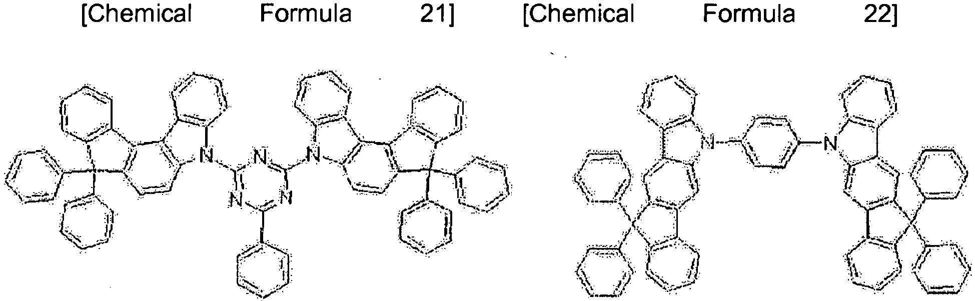

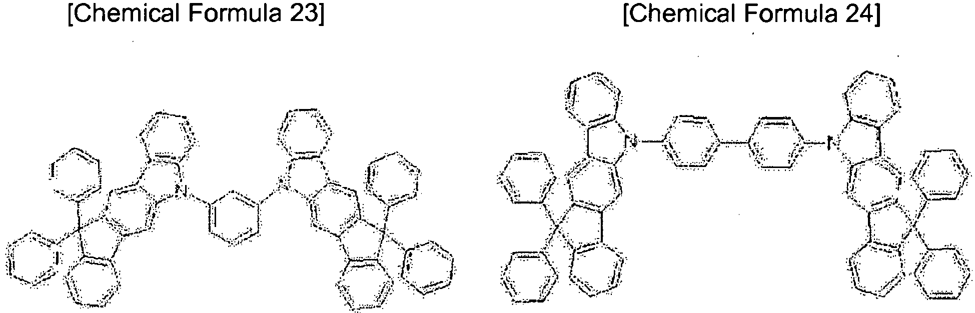

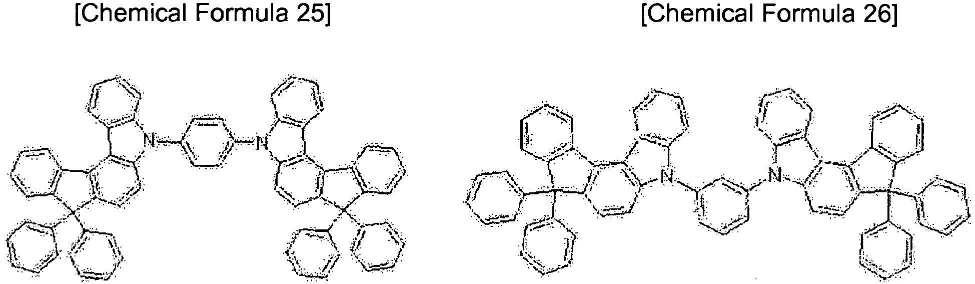

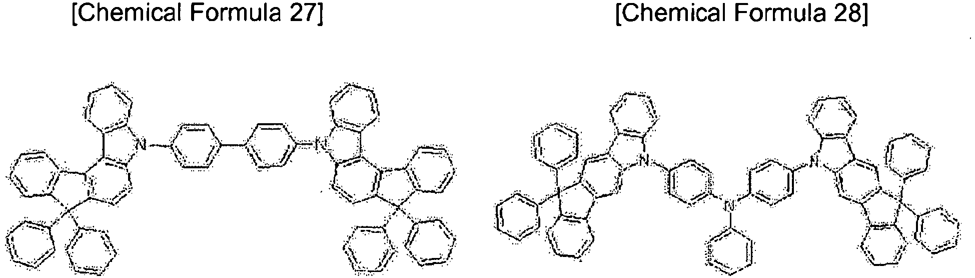

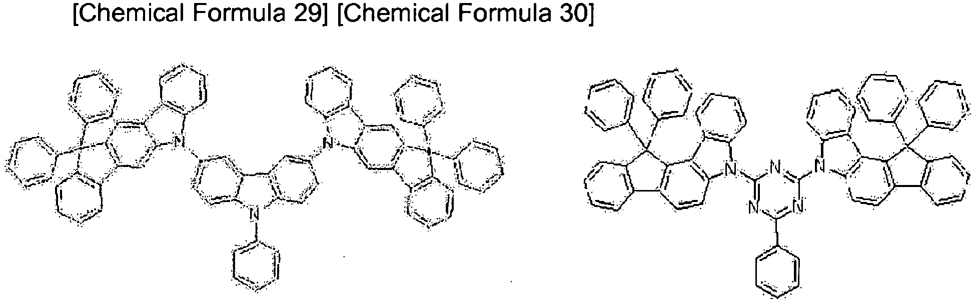

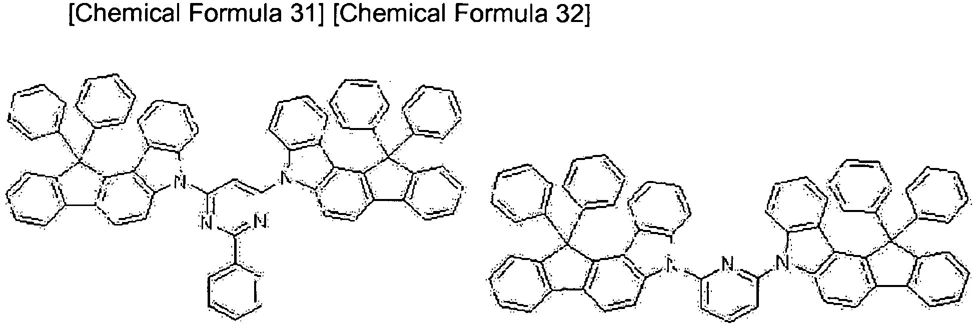

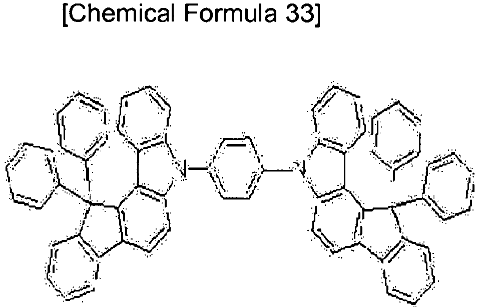

The compound for an organic optoelectronic device may be used as a charge transport material or a host material, and has a thermal decomposition temperature (Td) of 350 to 600 °C.

According to another embodiment of the present invention, provided is a organic light emitting diode that includes an anode, a cathode and at least one or more organic thin layer between the anode and the cathode, wherein the organic thin layer includes the compound for an organic optoelectronic device.

The organic thin layer may be an emission layer, a hole blocking layer, an electron transport layer (ETL), an electron injection layer (EIL), a hole injection layer (HIL), a hole transport layer (HTL), an electron blocking layer, or a combination thereof.

According to yet another embodiment of the present invention, a display device including the organic light emitting diode is provided.

Hereinafter, further embodiments of the present invention will be described in detail.

### [Advantageous Effects]

The compound for an organic optoelectronic device according to one embodiment has excellent thermal stability, and particularly, may be applied to an organic thin layer of an organic optoelectronic device and thus can provide an organic optoelectronic device and a display device having high luminous efficiency at a low voltage and improved life-span.

### [Description of the Drawings]

FIGS. 1 to 5 are cross-sectional views showing organic light emitting diodes including compounds according to various embodiments of the present invention.
FIG. 6 is a graph showing current density change depending on voltage of the organic light emitting diodes according to Example 3 and Comparative Example 1.
FIG. 7 is a graph showing luminance change depending on voltage of the organic light emitting diodes according to Example 3 and Comparative Example 1.
FIG. 8 is a graph showing current efficiency change depending on luminance of the organic light emitting diodes according to Example 3 and Comparative Example 1.
FIG. 9 is a graph showing electric power efficiency change depending on luminance of the organic light emitting diodes according to Example 3 and Comparative Example 1.

### <Description of Reference Numerals Indicating Primary Elements in the Drawings>

| | | | |
|---|---|---|---|
| 100: | organic light emitting diode | 110: | cathode |
| 120: | anode | 105: | organic thin layer |
| 130: | emission layer | 140: | hole transport layer (HTL) |
| 150: | electron transport layer (ETL) | 160: | electron injection layer (EIL) |
| 170: | hole injection layer (HIL) | 230: | emission layer + electron transport layer (ETL) |

### [Mode for Invention]

Exemplary embodiments of the present invention will hereinafter be described in detail. However, these embodiments are only exemplary, and the present invention is not limited thereto but rather is defined by the scope of the appended claims.

In the present specification, the term "substituted", when a definition is not otherwise provided, refers to one substituted with a halogen group, a cyano group, a C1 to C30 alkyl group, a C3 to C30 cycloalkyl group, a C6 to C30 aryl group, a C1 to C30 alkoxy group, or a combination thereof.

In the present specification the term "halogen group", when a definition is not otherwise provided, refers to a fluoro group, a chloro group, a bromo group, or a combination thereof, and particularly, a fluoro group.

In the present specification, the term "hetero", when a definition is not otherwise provided, refers to one including 1 to 3 of N, P, S, O, and remaining carbons.

In the present specification, the term "combination thereof", when a definition is not otherwise provided, refers to at least two substituents bound to each other by a single bond, or at least two substituents condensed to each other.

According to one embodiment of the present invention, a compound for an organic optoelectronic device including substituents represented by the following Chemical Formula 2 is provided.

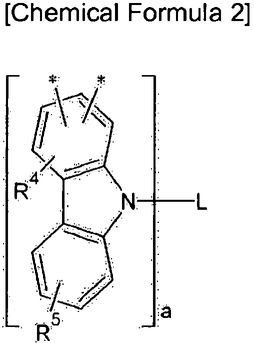

In Chemical Formula 2,
L is a divalent to heptavalent linking group that is an oxide group, an amine group, a phosphonyl group, a phsophonate group, a sulfonyl group, a sulfonate group, a substituted or unsubstituted C1 to C30 alkylene group, a substituted or unsubstituted C1 to C30 heteroalkylene group, a substituted or unsubstituted C3 to C30 cycloalkylene group, a substituted or unsubstituted C1 to C30 heterocycloalkylene group, a substituted or unsubstituted C6 to C30 arylene group, a substituted or unsubstituted C2 to C30 heteroarylene group, or a combination thereof. Herein, examples of the heterocycloalkylene may include a substituent such as pyrrolidine, tetrahydrofuran, tetrahydrothiophene, dioxane, dithiane, and the like, examples of the heteroarylene may include a substituent such as thiophene, furan, pyrrole, imidazole, thiazole, oxazole, oxadiazole, thiadiazole, triazole, triazine, pyridine, pyrimidine, pyridazine, pyrazine, quinoline, isoquinoline, and the like, and the "combination thereof" refers to a substituent such as carbazole, indolocarbazole, fluorene, fluorenone, benzofuran, benzothiophene, dibenzofuran, dibenzothiophene, oxanthrene, thianethrene, and the like. However, the L is not limited to the above described.
R¹ to R⁵ are the same or different and are each independently hydrogen, a carbazolyl group, a C1 to C30 alkyl group, a C6 to C30 aryl group, a C2 to C30 heteroaryl group, a C6 to C30 arylamine group, or a combination thereof, particularly, the R¹ and R² are the same or different, and are each independently a carbazolyl group, a C1 to C30 alkyl group, a C6 to C30 aryl group, a C2 to C30 heteroaryl group, or a combination thereof, and R³ to R⁵ are the same or different, and are each independently hydrogen, a C1 to C30 alkyl group, a C6 to C30 aryl group, or a combination thereof.

When the R¹ to R⁵ are a C6 to C30 aryl group, the aryl group may be a phenyl group, a naphthyl group, an anthracene group, a phenanthrene group, a tetracene group, a pyrene group, a fluorene group, or a combination thereof. However, the aryl group is not limited to the above described.

When the R¹ to R⁵ are a C2 to C30 heteroaryl group, the heteroaryl group may be thiophene, furan, pyrrole, imidazole, thiazole, oxazole, oxadiazole, thiadiazole, triazole, triazine, pyridine, pyrimidine, pyridazine, pyrazine, quinoline, isoquinoline, or a combination thereof. However, the heteroaryl group is not limited to the above described.
a is an integer ranging from 2 to 5, and each repeating unit may be the same or different.

The Chemical Formula 1 a.

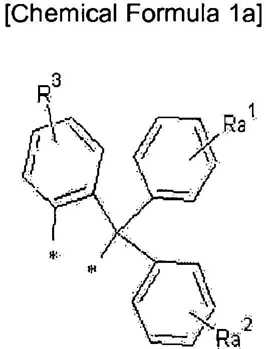

In Chemical Formula 1 a,
Ra¹ and Ra² are the same or different, and are each independently hydrogen or a C1 to C10 alkyl group, and
R³ is hydrogen, a carbazolyl group, a C1 to C30 alkyl group, a C6 to C30 aryl group, a C2 to C30 heteroaryl group, a C6 to C30 arylamine group, or a combination thereof.

The Chemical Formula 2 may be represented by one of the following Chemical Formulas 2a to 2c.

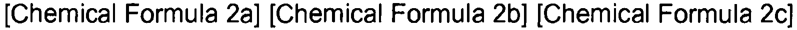

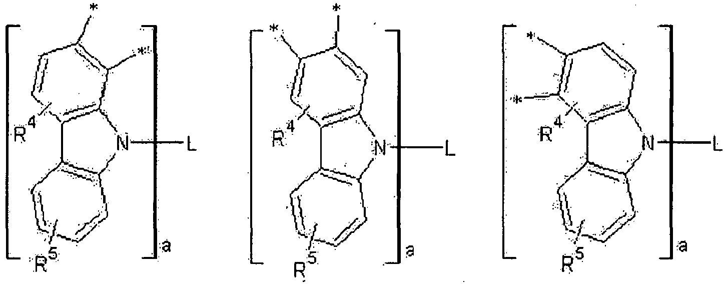

In Chemical Formulas 2a to 2c,
L is a divalent to heptavalent linking group that is an oxide group, an amine group, a phosphonyl group, a phsophonate group, a sulfonyl group, a sulfonate group, a substituted or unsubstituted C1 to C30 alkylene group, a substituted or unsubstituted C1 to C30 heteroalkylene group, a substituted or unsubstituted C3 to C30 cycloalkylene group, a substituted or unsubstituted C1 to C30 heterocycloalkylene group, a substituted or unsubstituted C6 to C30 arylene group, a substituted or unsubstituted C2 to C30 heteroarylene group, or a combination thereof,
R⁴ and R⁵ are the same or different and are each independently hydrogen, a carbazolyl group, a C1 to C30 alkyl group, a C6 to C30 aryl group, a C2 to C30 heteroaryl group, a C6 to C30 arylamine group, or a combination thereof, and
a is an integer ranging from 2 to 5.

The L of the above Chemical Formula 2 may be a divalent to heptavalent linking group derived from the compounds represented by the following Chemical Formulas 2d to 2j or a combination thereof.

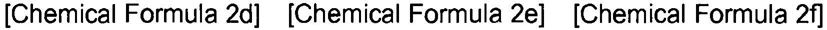

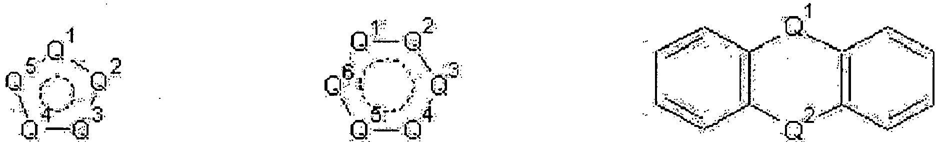

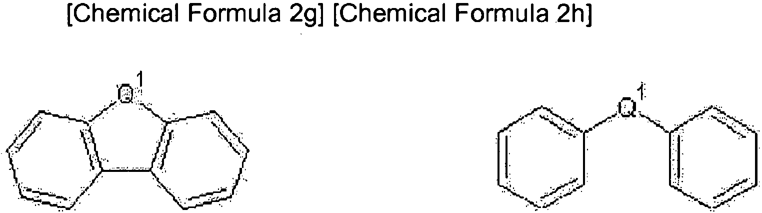

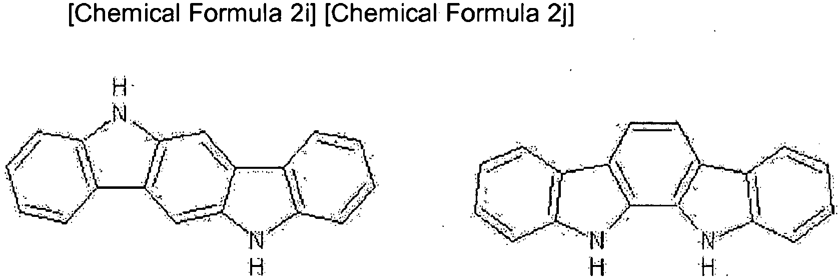

In Chemical Formulas 2d to 2j,
Q¹ to Q⁶ are the same or different, and are each independently a substituted or unsubstituted N atom, a substituted or unsubstituted P atom, a substituted or unsubstituted S atom, a substituted or unsubstituted O atom, a substituted or unsubstituted C atom, or a combination thereof, wherein the substituted refers to one substituted with hydrogen, an oxide group, a cyano group, a halogen group, a C1 to C30 alkyl group, a C6 to C30 aryl group, a C2 to C30 heteroaryl group, or a combination thereof.

In Chemical Formula 2, a may be 2 or 3.
L of the above Chemical Formula 2 may be represented by the above Chemical Formula 2k. However, the L is not limited thereto.

The compound for an organic optoelectronic device may be represented by the following Chemical Formulas 3 to 8.

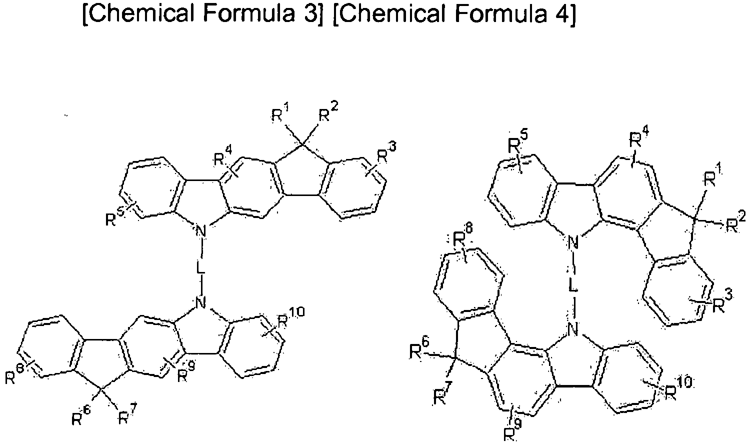

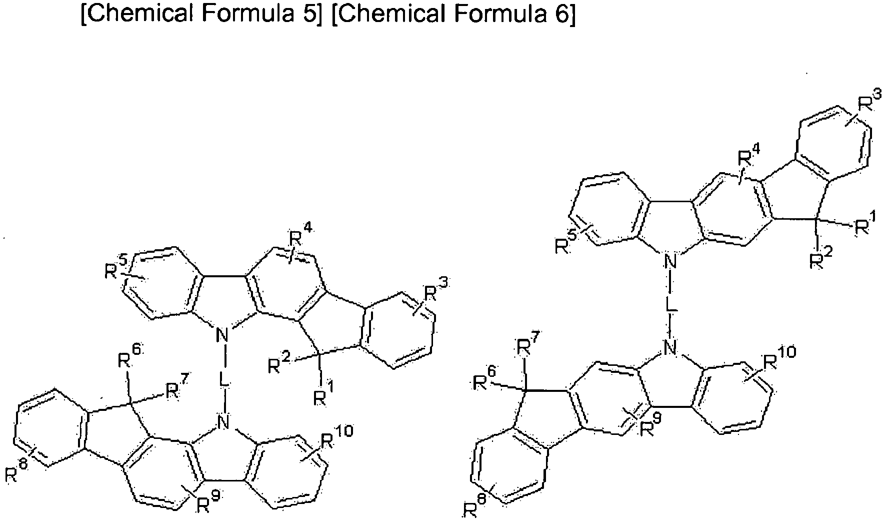

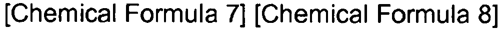

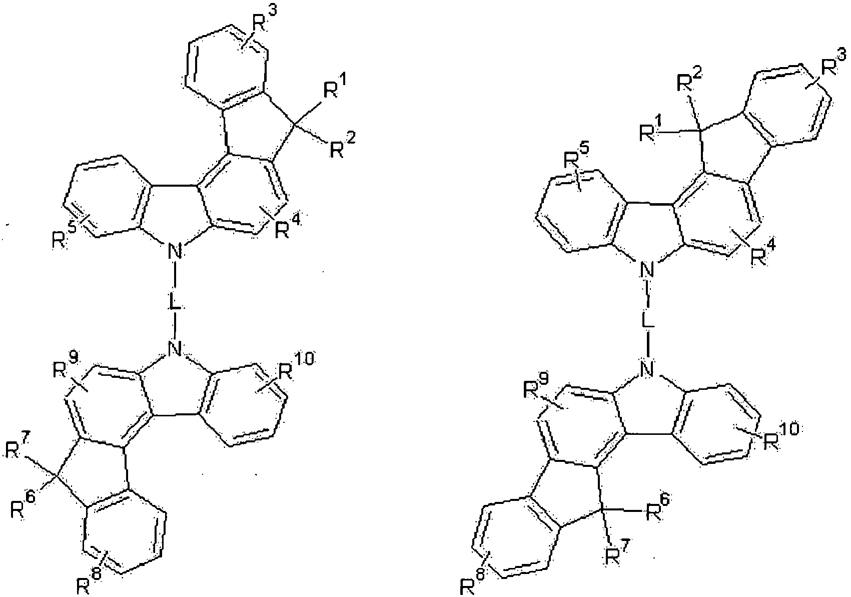

In Chemical Formulas 3 to 8,
L is a divalent linking group that is a substituted or unsubstituted C2 to C30 heteroarylene group
R¹, R⁶ are phenyl-Ra¹,
R², R⁷ are phenyl-Ra², and
R³ to R⁵, and R⁸ to R¹⁰ are the same or different, and are each independently hydrogen, a carbazolyl group, a C1 to C30 alkyl group, a C6 to C30 aryl group, a C2 to C30 heteroaryl group, a C6 to C30 arylamine group, or a combination thereof.

The compound for an organic optoelectronic device may be represented by the above Chemical Formulas 9 to 33. However, the compound for an organic optoelectronic device is not limited thereto.

The compound for an organic optoelectronic device may be used as a charge transport material or a host material, and particularly, when the compound for an organic optoelectronic device may be used as a host material, the compound is a phosphorescent host material that lowers a driving voltage of an organic photoelectric device, and improves luminous efficiency.

When the compound for an organic optoelectronic device is a host material, the compound for an organic optoelectronic device may be used as a mixture or blend with a generally-used low molecular host material or a polymer host material. In addition, a binder resin such as polyvinylcarbazole, polycarbonate, polyester, poly arylate, polystyrene, acryl polymer, methacryl polymer, polybutyral, polyvinylacetal, a diallylphthalate polymer, phenolic resin, an epoxy resin, a silicone resin, polysulfone resin, or a urea resin may be mixed.

For example, for the low molecular host material, the compounds represented by the following Chemical Formulas 34 to 37, and for the polymer host material, a polymer having a conjugated double bond such as a fluorene-based polymer, a polyphenylenevinylene-based polymer, a polyparaphenylene-based polymer, and the like may be used. However, the low molecular host material and polymer host material are not limited to the above described.

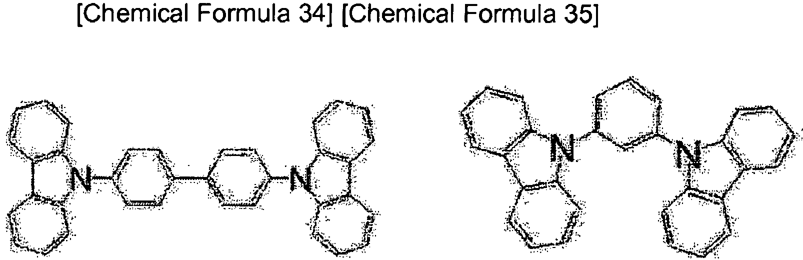

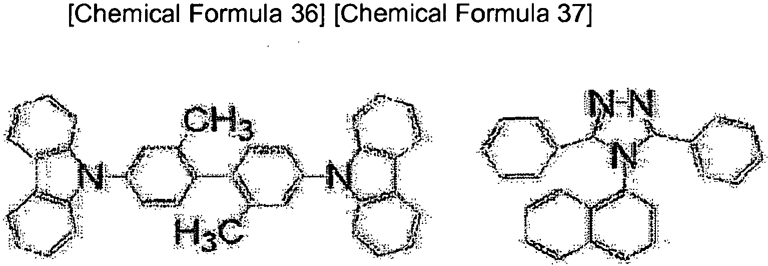

When the compound for an organic optoelectronic device is used as a host material, the compound for an organic optoelectronic device may be used singularly or along with a dopant as a host material. The dopant is a compound having a high emission property, by itself. However, it is usually added to a host in a minor amount, so it is also called a guest. The dopant may be a light-emitting material while being doped on a host material. Generally, a material such as a metal complex being capable of light-emitting by multiplet excitations such as triplet excitation or more is used for a dopant. Such a dopant may be a generally-used red (R), green (G), blue (B), or white (W) fluorescent or phosphorescent dopant, and particularly, red, green and blue, or white phosphorescent dopant is preferable. A material that has high luminous efficiency, is not agglomerated, and is distributed in a host material uniformly may be used.

The phosphorescent dopant may be an organic metal compound including an element that is Ir, Pt, Os, Ti, Zr, Hf, Eu, Tb, Tm, Fe, Co, Ni, Ru, Rh, Pd, or a combination thereof. More particularly, a red phosphorescent dopant may include platinum-octaethylporphyrin complex (PtOEP), Ir(btp)₂(acac) (bis(2-(2'-benzothienyl)-pyridinato-N,C3')iridium(acetylacetonate)), Ir(Piq)₂(acac), Ir(Piq)₃, RD61 (UDC), and the like, a green phosphorescent dopant may include Ir(PPy)₂(acac), Ir(PPy)₃, GD48 (UDC), and the like, and a blue phosphorescent dopant may include (4,6-F₂PPy)₂Irpic, fIrpic(Ir bis[4,6-di-fluorophenyl)-pyridinato-N,C2']picolinate), and the like. The "Piq" denotes 1-phenylisoquinoline, "acac" denotes acetylacetonate, and PPy denotes 2-phenylpyridine.

The compound for an organic optoelectronic device according to one embodiment of the present invention has a thermal decomposition temperature (Td) ranging from 350 to 600 °C. Thereby, the compound for an organic optoelectronic device according to one embodiment of the present invention has excellent thermal stability and may be used as a host material or a charge transport material. Therefore, life-span of the organic optoelectronic device may be improved.

According to another embodiment of the present invention, an organic optoelectronic device includes an anode, a cathode and an organic thin layer between the anode and the cathode, wherein the organic thin layer includes the compound for an organic optoelectronic device according to one embodiment. The organic optoelectronic device may include an organic photoelectronic device, an organic light emitting diode, an organic solar cell, an organic transistor, organic photo conductor drum, an organic memory device, and the like. In case of an organic solar cell, the compound for an organic optoelectronic device according to one embodiment may be applied to an electrode or an electrode buffer layer of an organic solar cell to improve quantum efficiency, or may be applied to an electrode material of a gate, source-drain electrodes, and the like of an organic transistor.

The organic thin layer including the compound for an organic optoelectronic device may be an emission layer, a hole blocking layer, an electron transport layer (ETL), an electron injection layer (EIL), a hole injection layer (HIL), a hole transport layer (HTL), an electron blocking layer, or a combination thereof.

Hereinafter, an organic light emitting diode is illustrated in more detail.

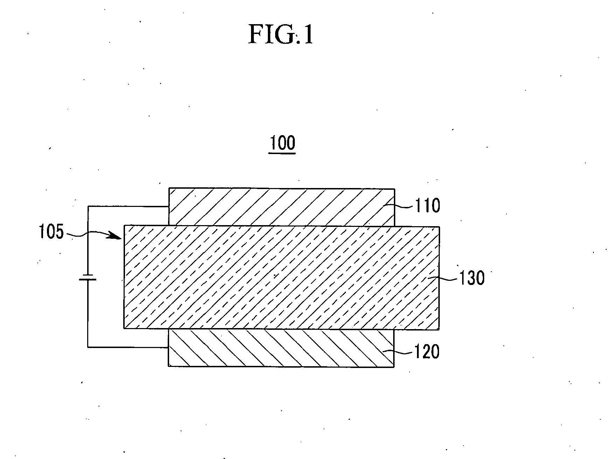

FIGS. 1 to 5 are cross-sectional views showing organic light emitting diodes including the compound for an organic optoelectronic device.

Referring to FIGS. 1 to 5, the organic light emitting diodes 100, 200, 300, 400, and 500 according to one embodiment includes at least one organic thin layer 105 interposed between an anode 120 and a cathode 110.

A substrate of an organic light emitting diode is not particularly limited in the related arts, but a glass substrate or a transparent plastic substrate having excellent transparency, surface smoothness, handling ease, and water repellency.

The anode 120 includes an anode material laving a large work function to help hole injection into an organic thin layer. The anode material includes a metal such as nickel, platinum, vanadium, chromium, copper, zinc, gold, and the like or an alloy of the foregoing metals; metal oxide such as zinc oxide, indium oxide, indium tin oxide (ITO), indium zinc oxide (IZO), and the like; a combined metal and oxide such as ZnO/Al, SnO₂/Sb, and the like. But the anode material is not limited thereto. Particularly, the anode material may be a transparent electrode including ITO.

The cathode 110 includes a cathode material having a small work function to help electron injection into an organic thin layer. The cathode material includes a metal such as magnesium, calcium, sodium, potassium, titanium, indium, yttrium, lithium, gadolinium, aluminum, silver, tin, lead, cesium, barium, and the metal, or alloys thereof; or a multi-layered material such as LiF/Al, LiO₂/Al, LiF/Ca, LiF/Al, BaF₂/Ca, and the like. But the cathode material is not limited to the above materials. Particularly, the cathode material may be a metal electrode such as aluminum.

Referring to FIG. 1, the organic light emitting diode 100 includes an organic thin layer 105 including only an emission layer 130.

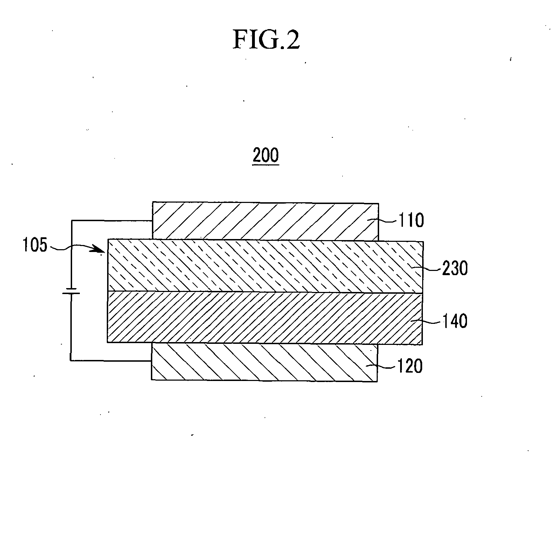

Referring to FIG. 2, a double-layered organic light emitting diode 200 includes an organic thin layer 105 including an emission layer 230 including an electron transport layer (ETL), and a hole transport layer (HTL) 140. The emission layer 130 also functions as an electron transport layer (ETL), and the hole transport layer (HTL) 140 layer has an excellent binding property with a transparent electrode such as ITO or an excellent hole transporting property.

The hole transport layer (HTL) 140 may include generally-used hole transport material without limitation, for example poly (3,4-ethylenedioxy-thiophene) (PEDOT) doped with poly(styrenesulfonate) (PSS) (PEDOT:PSS), N,N'-bis (3-methylphenyl)-N,N-diphenyl-[1,1'-biphenyl]-4,4'-diamine (TPD), N,N'-di (1-naphthyl)-N,N'-diphenylbenzidine (NPB) and the like, along with the compound for an organic optoelectronic device according to one embodiment of the present invention. The hole transport material is not limited to the above materials.

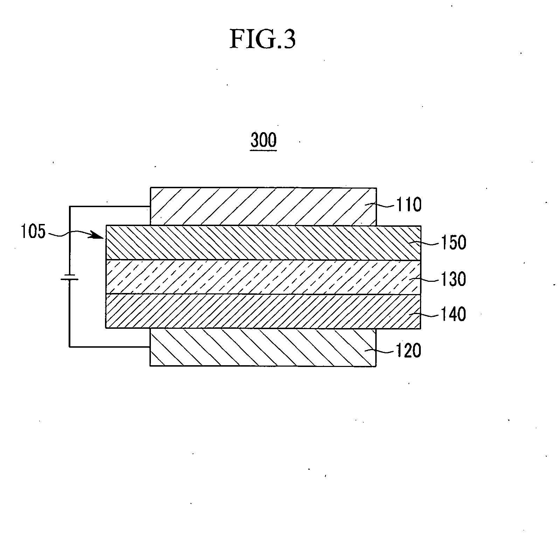

Referring to FIG. 3, a three-layered organic light emitting diode 300 includes an organic thin layer 105 including an electron transport layer (ETL) 150, an emission layer 130, and a hole transport layer (HTL) 140. The emission layer 130 is independently installed, and layers having an excellent electron transporting property or an excellent hole transporting property are separately stacked.

The electron transport layer (ETL) 150 may include generally-used electron transport material without limitation, for example, aluminum tris(8-hydroxyquinoline) (Alq₃); a 1,3,4-oxadiazole derivative such as 2-(4-biphenyl-5-phenyl-1,3,4-oxadiazole (PBD); a quinoxalin derivative such as 1,3,4-tris[(3-phenyl-6-trifluoromethyl) quinoxalin-2-yl]benzene (TPQ); and a triazole derivative, along with the compound for an organic optoelectronic device according to one embodiment of the present invention. The electron transport material is not limited to the above materials.

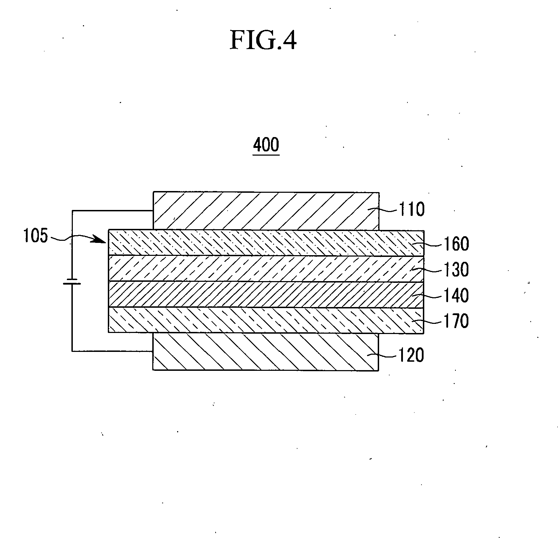

FIG. 4 shows a four-layered organic light emitting diode 400 that includes an organic thin layer 105 including an electron injection layer (EIL) 160, an emission layer 130, a hole transport layer (HTL) 140, and a hole injection layer (HIL) 170 for binding with the cathode of ITO.

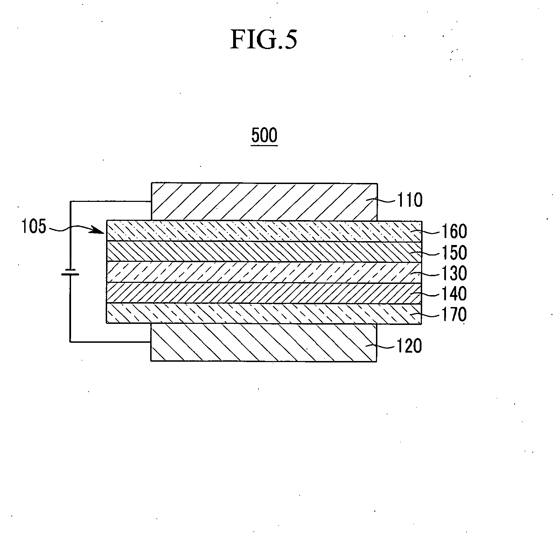

FIG. 5 shows a five layered organic light emitting diode 500 that includes an organic thin layer 105 including an electron transport layer (ETL) 150, an emission layer 130, a hole transport layer (HTL) 140, and a hole injection layer (HIL) 170, and further includes an electron injection layer (EIL) 160 to achieve a low voltage.

The emission layers 130 and 230 may have a thickness of 5 to 1000 nm, the hole transport layer (HTL) 140 and electron transport layer (ETL) 150 may have a thickness of 10 to 10,000 Å, respectively. However, the thicknesses are not limited to the above range.

In FIGS. 1 to 5, the organic thin layer 105 selected from the electron transport layer (ETL) 150, electron injection layer (EIL) 160, emission layer 130 and 230, hole transport layer (HTL) 140, hole injection layer (HIL) 170 and a combination thereof includes the compound for an organic optoelectronic device according to one embodiment. The material for the organic optoelectronic device may be used for an electron transport layer (ETL) 150 including the electron transport layer (ETL) 150 or electron injection layer (EIL) 160. When it is used for the electron transport layer (ETL), it is possible to provide an organic optoelectronic device having a simpler structure because it does not require an additional hole blocking layer.

Furthermore, when the compound for an organic optoelectronic device is included in the emission layer 130 and 230, the material for the organic optoelectronic device may be included as a phosphorescent host, and the emission layer 130 and 230 may further include a dopant. The dopant may be a red, green and blue, or white phosphorescent dopant.

The organic light emitting diode may be fabricated by: forming an anode on a substrate, forming an organic thin layer in accordance with a dry coating method such as evaporation, sputtering, plasma plating, and ion plating, or a wet coating method such as spin coating, dipping, and flow coating; and providing a cathode thereon.

Another embodiment of the present invention provides a display device including the organic organic light emitting diode.

Hereinafter, the embodiments are illustrated in more detail with reference to examples. However, the following are exemplary embodiments and are not limiting.

### Synthesis of Compound for organic optoelectronic device

### Example 1

A compound for an organic optoelectronic device was synthesized according to the following Reaction Scheme 1.

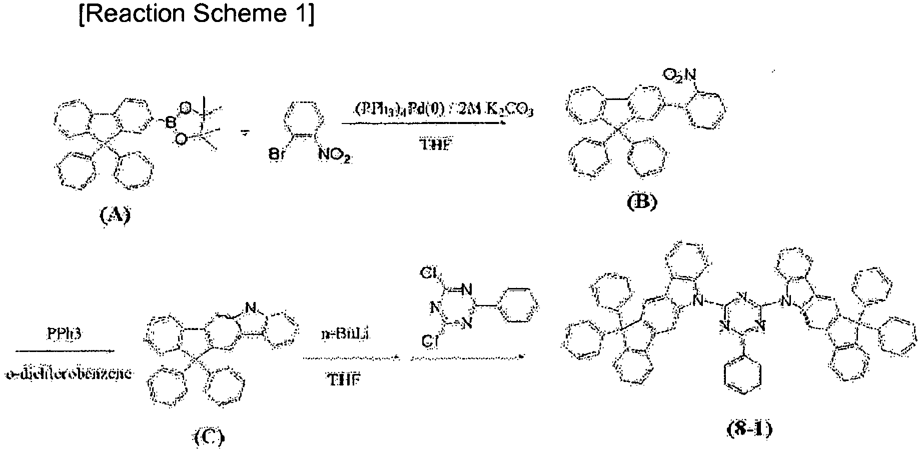

### First step: Synthesis of Intermediate product (B)

11.0 g (24.7 mmol) of a compound A, 6.0 g (29.7 mmol) of 1-bromo-2-nitro benzene, and 1 g (0.86 mmol) of tetrakistriphenylphosphine palladium were mixed with 200 mL of tetrahydrofuran (THF) in a 500 mL round-bottomed flask with a thermometer, a reflux-condenser, and an agitator under an argon atmosphere, and 250 mL of 2M potassium carbonate was added thereto. The resulting mixture was agitated at 75 °C for 24 hours.

The reactant was cooled down to complete the reaction and then, extracted with methylene chloride, and cleaned with water. Next, the resulting reactant was treated with anhydrous magnesium sulfate to remove moisture therein and then, filtrated to remove an organic solvent. The final residue was purified through silica gel chromatography using a mixed solvent prepared by mixing methylene chloride and hexane in a volume ratio of 1:1, obtaining 9 g of an intermediate product (B) (a yield: 82.7 %).

### Second step: Synthesis of Intermediate product (C)

8 g (18.2 mmol) of the intermediate product (B) synthesized in the first step and 14.3 g (54.6 mmol) of triphenylphosphine were dissolved in 150 ml of dichlorobenzene, and the solution was heated and refluxed at 160 °C under an argon atmosphere.

The organic solvent was distillated and removed under reduced pressure and then, extracted with methylene chloride and cleaned with water. Then, the reactant was treated with anhydrous magnesium sulfate to remove moisture therein and then, filtrated to remove the organic solvent remaining there. The final residue was purified through silica gel chromatography using a mixed solvent prepared by mixing methylene chloride and hexane in a volume ratio of 2:1, obtaining 5.3 g of an intermediate product (C) (a yield: 71.5 %).

### Third step: Synthesis of Compound for organic optoelectronic device

5 g (12.2 mmol) of the intermediate product (C) synthesized in the second was dissolved in 100 mL of anhydrous tetrahydrofuran (THF), and 9.2 mL of 1.6 M n-BuLi was slowly added thereto in a dropwise fashion at -78 °C. The mixture was agitated for 30 minutes. Subsequently, the mixture was further agitated at a room temperature for 20 minutes and mixed with 1.32 g (5.8 mmol) of 2,4-dichloro-6-phenyl triazine at -78 °C. The resulting mixture was agitated at a room temperature for 12 hours.

Then, the reactant was cooled down to a room temperature to complete the reaction and then, extracted with methylene chloride and washed with water. The resulting reactant was treated with anhydrous magnesium sulfate to remove moisture and then, filtrated to remove the organic solvent therein. The final residue was purified and recrystallized through silica gel chromatography using a mixed solvent prepared by mixing methylene chloride and hexane in a volume ratio of 1:3, obtaining 2.7 g of a compound for an organic optoelectronic device (a yield: 48.0 %).

The compound for an organic optoelectronic device was performed regarding atomic analysis. The result is provided as follows;
Calcd. C, 88.08; H, 4.68, N, 7.23
Found. C, 88.10; H, 4.66, N, 7.23

### Example 2

A compound for an organic optoelectronic device was synthesized according to the following Reaction Scheme 2.

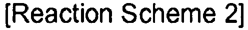

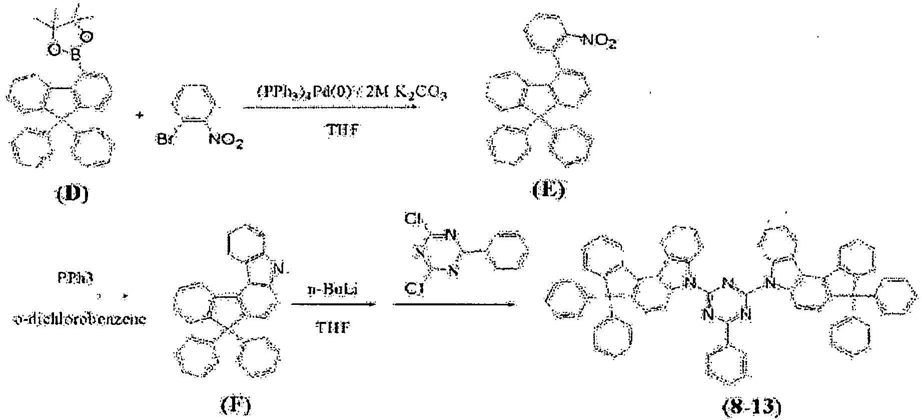

### First step: Synthesis of Intermediate product (E)

10.0 g (22.5 mmol) of the compound D, 5.45 g (27.0 mmol) of 1-bromo-2-nitro benzene, and 1 g (0.86 mmol) of tetrakistriphenylphosphinepalladium were dissolved in 200 mL of tetrahydrofuran in a 500 mL round-bottomed flask with a thermometer, a reflux-condenser, and an agitator under an argon atmosphere, and 50 mL of tetratriethyl ammonium hydroxide with 20% of a concentration was added thereto. The mixture was agitated at 75 °C for 24 hours.

Next, the reactant was cooled down to complete the reaction and then, extracted with methylene chloride and washed with water. Then, the resulting reactant was treated with anhydrous magnesium sulfate to remove moisture therein and then, filtrated to remove the organic solvent. The final residue was purified through silica gel chromatography using a mixed solvent prepared by mixing methylene chloride and hexane in a volume ratio of 1:1, obtaining 7.8 g of an intermediate product (E) (a yield: 78.8 %).

### Second step: Synthesis of Intermediate product (F)

7 g (15.9 mmol) of the intermediate product (E) synthesized in the first step and 14.3 g (54.6 mmol) of triphenylphosphine were dissolved in 150 ml of dichlorobenzene, and the solution was heated and refluxed at 160 °C under an argon atmosphere.

The resulting reactant was distillated under a reduced pressure to remove the organic solvent and then, extracted with methylene chloride and washed with water. Then, the reactant was treated with anhydrous magnesium sulfate to remove moisture and then, filtrated to remove the organic solvent. The final residue was purified through silica gel chromatography using a mixed solvent prepared by mixing methylene chloride and hexane in a volume ratio of 2:1, obtaining 4.4 g of an intermediate product (F) (a yield: 68 %).

### Third step: Synthesis of Compound for organic optoelectronic device

4 g (9.8 mmol) of the intermediate product (F) synthesized in the second step was dissolved in 100 mL of anhydrous tetrahydrofuran (THF), and 9.2 mL of 1.6 M n-BuLi was slowly added in a dropwise fashion thereto at -78 °C for 30 minutes. The resulting mixture was further agitated at a room temperature for 20 minutes and then, mixed with 1 g (4.4 mmol) of 2,4-dichloro-6-phenyl triazine at -78 °C. The mixture was agitated at a room temperature for 12 hours.

The agitated reactant was cooled down to a room temperature to complete the reaction and then, extracted with methylene chloride and washed with water. Next, the reactant was treated with anhydrous magnesium sulfate to remove moisture and filtrated to remove the organic solvent. The final residue was purified and recrystallized through silica gel chromatography using a mixed solvent prepared by mixing methylene chloride and hexane in a volume ratio of 1:3, obtaining 1.8 g of a compound for an organic optoelectronic device (a yield: 42.3 %).

The obtained compound for an organic optoelectronic device was performed regarding atomic analysis. The result is provided as follows;
Calcd. C, 88.08; H, 4.68, N, 7.23
Found. C, 88.06; H, 4.70, N, 7.23

### Preparation of Organic light emitting diode

### Example 3

An organic light emitting diode was fabricated by using the compound synthesized in Example 1 as a host and Ir(PPy)₃ as a dopant. Herein, a 1000 A-thick ITO was used as an anode, while a 1500 A-thick aluminum (Al) was used as a cathode.

In particular, a method of manufacturing the organic light emitting diode includes preparing an anode by cutting an ITO glass substrate with 15 Ω/cm² of sheet resistance into a size of 50 mm × 50 mm × 0.7 mm, respectively cleaning the substrate in acetone, isopropylalcohol, and pure water for 15 minutes using ultrasonic wave and UV ozone-cleaning it for 30 minutes.

On the substrate, a 800 A-thick hole transport layer (HTL) was formed by depositing N,N'-di(1-naphthyl)-N,N'-diphenylbenzidine (NPB) (70 nm) and 4,4',4"-tri(N-carbazoleyl)triphenylamine (TCTA) (10 nm) under a vacuum degree of 650 × 10⁻⁷ Pa at a speed ranging from 0.1 to 0.3 nm/s.

Next, the compound synthesized according to Example 1 was deposited to form a 300 A-thick emission layer under the same condition, and Ir(PPy)₃ as a phosphorescent dopant was simultaneously deposited. Herein, the phosphorescent dopant was regulated regarding deposition speed to be deposited in an amount of 10 wt% based on 100 wt% of the total weight of the emission layer.

On the emission layer, a 50 A-thick hole blocking layer was formed by depositing bis(8-hydroxy-2-methylquinolinato)-aluminum biphenoxide (BAlq) under the same vacuum condition.

Next, a 200 A-thick electron transport layer (ETL) was formed by depositing Alq₃ under the same vacuum condition.

Then, LiF and Al were sequentially deposited on the electron transport layer (ETL) to form a cathode, fabricating an organic light emitting diode.

The organic light emitting diode had a structure of ITO/ NPB (70 nm)/ TCTA (10 nm)/ EML (the compound of Example 1 (90 wt%) + Ir(PPy)₃ (10 wt%), 30 nm)/ Balq (5 nm)/ Alq₃ (20 nm)/ LiF (0.5 nm) / Al (150 nm).

### Comparative Example 1

An organic light emitting diode was fabricated according to the same method as Example 3 except for using 4,4-N,N-dicarbazolebiphenyl (CBP) as a host for an emission layer instead of the compound synthesized according to Example 1 as a host for an emission layer.

### Experimental Example 1: Performance Evaluation of Organic light emitting diode

The organic light emitting diodes according to Example 3 and Comparative Example 1 were measured regarding current density change and luminance change depending on a voltage and luminous efficiency. Specifically, the measurement was performed as follows. The result is provided in the following Table 1.

### (1) Current density change depending on Voltage change

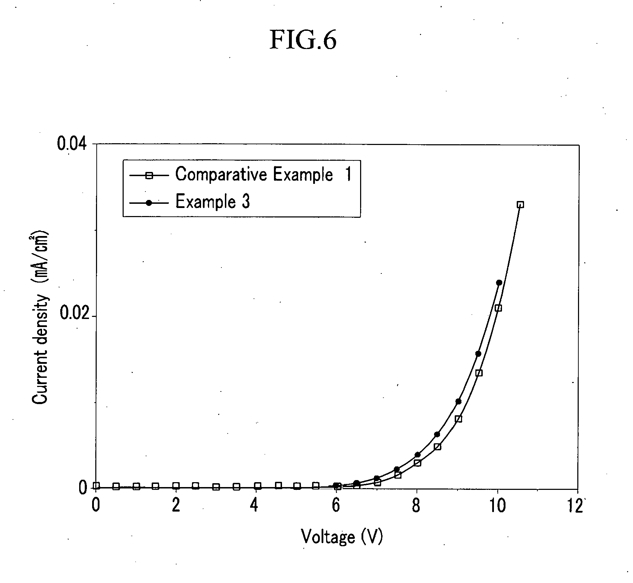

The organic light emitting diodes were measured regarding current using a current-voltage meter (Keithley 2400) while their voltages were increased from 0 V to 10 V. The current values were divided by an area to calculate current density. The results are provided in FIG. 6.

### (2) Luminance change depending on Voltage change

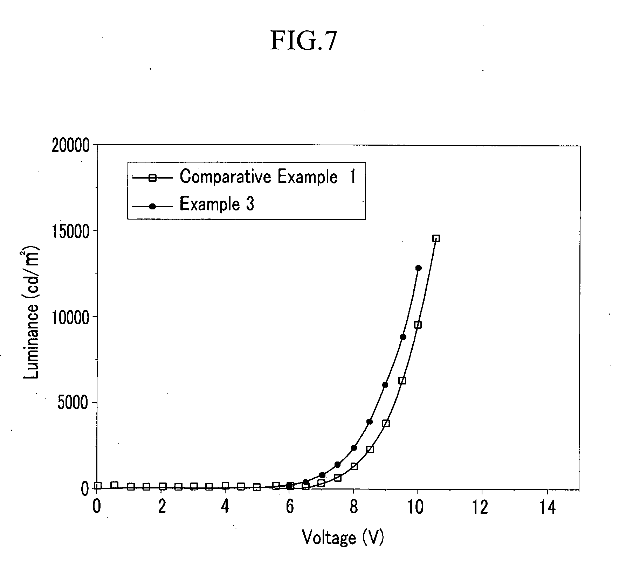

The organic light emitting diodes were measured regarding luminance using a luminance meter (Minolta Cs-1000A) while their voltages were increased from 0 V to 10 V. The results are provided in FIG. 7.

### (3) Luminous efficiency

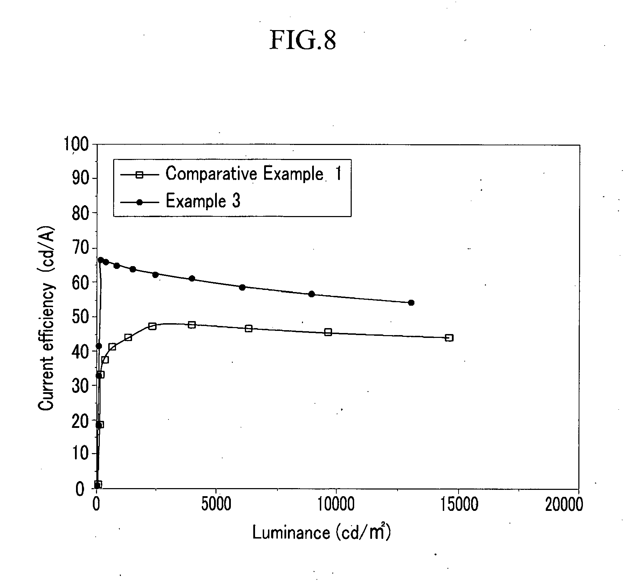

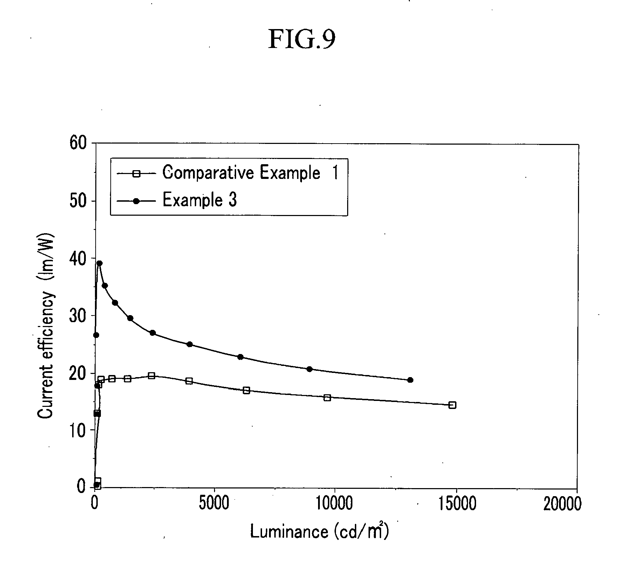

The luminance and current density obtained from the above (1) and (2) and a voltage were used to calculate current efficiency (cd/A) and electric power efficiency (lm/W) at the same luminance (2000 cd/m²). The results are provided in FIGS. 8 and 9.

### (4) Color coordinate

The organic light emitting diodes were measured regarding color coordinate using a luminance meter (Minolta Cs-100A). The results are provided in the following Table 1.

**(Table 1)**

| Device | Host material of emission layer | At 2000 cd/m² | | | |
|---|---|---|---|---|---|
| | | Driving voltage (V) | Current efficiency (cd/A) | Electric power efficiency (lm/W) | Color coordinate (x,y) |
| Example 3 | Example 1 | 7.7 | 63.2 | 28.4 | 0.301, 0.622 |
| Comparative Example 1 | CBP | 8.3 | 46.3 | 19.1 | 0.293, 0.622 |

Referring to Table 1, the organic light emitting diode of Example 3 had low driving voltage and much improved current efficiency and electric power efficiency compared with the organic light emitting diode of Comparative Example 1 based on the characteristic evaluation results. The compound of Example 1 was identified to lower driving voltage of the organic light emitting diode and to improve its luminance and efficiency.

While this invention has been described in connection with what is presently considered to be practical exemplary embodiments, it is to be understood that the invention is not limited to the disclosed embodiments. Therefore, the aforementioned embodiments should be understood to be exemplary but not limiting the present invention in any way.

## Claims

1. A compound for an organic photoelectric device comprising substituents represented by the following Chemical Formulas 1 a and 2: 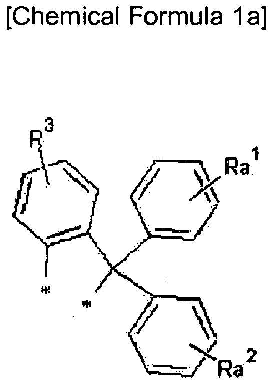 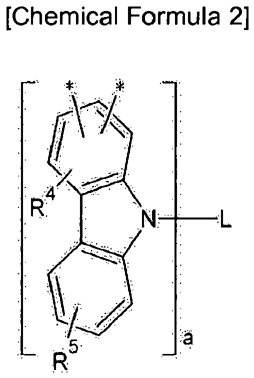 wherein, in Chemical Formulas 1a and 2,
L is a divalent linking group that is a substituted or unsubstituted C2 to C30 heteroarylene group,
Ra¹ and Ra² are the same or different, and are each independently hydrogen or a C1 to C10 alkyl group, and
R³ is hydrogen, a carbazolyl group, a C1 to C30 alkyl group, a C6 to C30 aryl group, a C2 to C30 heteroaryl group, a C6 to C30 arylamine group, or a combination thereof,
R⁴ and R⁵ are the same or different and are each independently hydrogen, a carbazolyl group, a C1 to C30 alkyl group, a C6 to C30 aryl group, a C2 to C30 heteroaryl group, a C6 to C30 arylamine group, or a combination thereof, and
a is an integer of 2.

2. The compound for an organic photoelectric device of claim 1, wherein R³ to R⁵ in Chemical Formulas 1a and 2 are the same or different, and are each independently hydrogen, a C1 to C30 alkyl group, a C6 to C30 aryl group, or a combination thereof.

3. The compound for an organic photoelectric device of claim 1, wherein the above Chemical Formula 2 is represented by one of the following Chemical Formulas 2a to 2c: 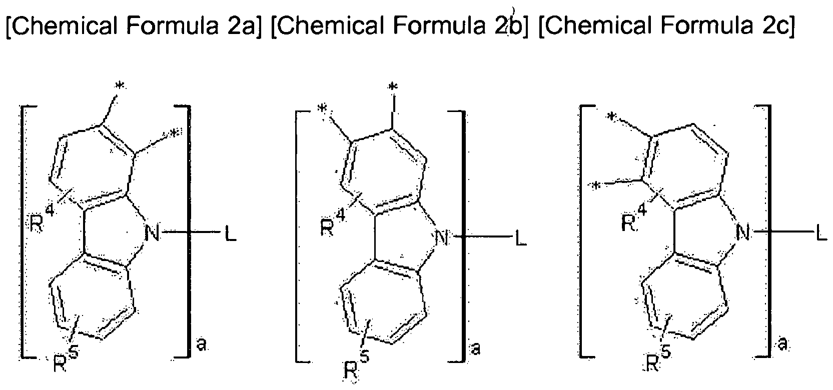 wherein, in Chemical Formulas 2a to 2c,
L is a divalent linking group that is a substituted or unsubstituted C2 to C30 heteroarylene group,
R⁴ and R⁵ are the same or different and are each independently hydrogen, a carbazolyl group, a C1 to C30 alkyl group, a C6 to C30 aryl group, a C2 to C30 heteroaryl group, a C6 to C30 arylamine group, or a combination thereof, and
a is an integer of 2.

4. The compound for an organic photoelectric device of claim 1, wherein the L of the above Chemical Formula 2 is a divalent linking group derived from compounds represented by the following Chemical Formulas 2d to 2g, 2i and 2j or a combination thereof: 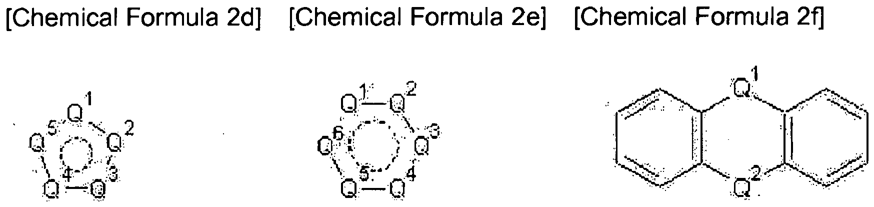 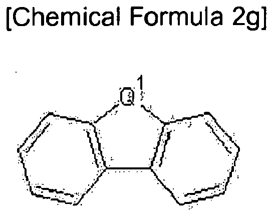 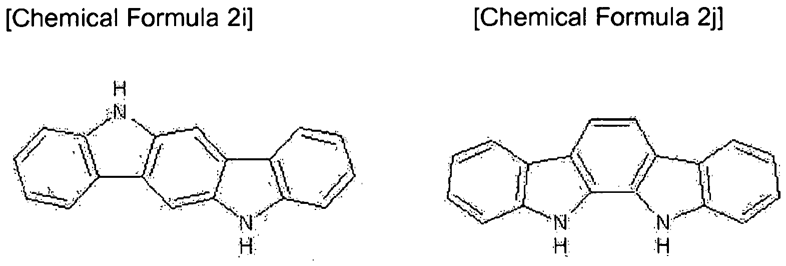 wherein, in Chemical Formulas 2d to 2g, 2i and 2j,
Q¹ to Q⁶ are the same or different, and are each independently a substituted or unsubstituted N atom, a substituted or unsubstituted P atom, a substituted or unsubstituted S atom, a substituted or unsubstituted O atom, a substituted or unsubstituted C atom, or a combination thereof, wherein the substituted refers to one substituted with hydrogen, an oxide group, a cyano group, a halogen group, a C1 to C30 alkyl group, a C6 to C30 aryl group, a C2 to C30 heteroaryl group, or a combination thereof.

5. The compound for an organic photoelectric device of claim 1, wherein L of the above Chemical Formula 2 is represented by the following Chemical Formula 2k:

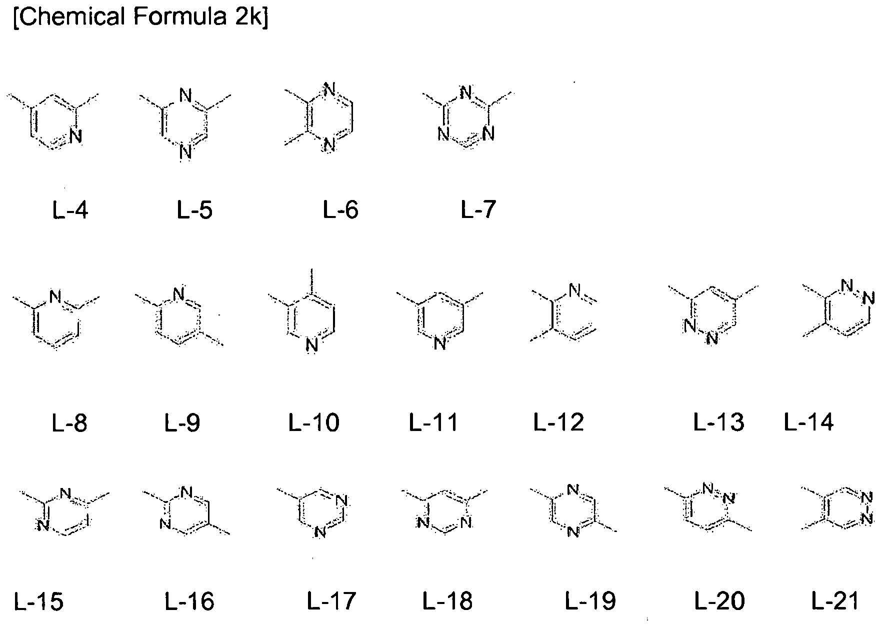

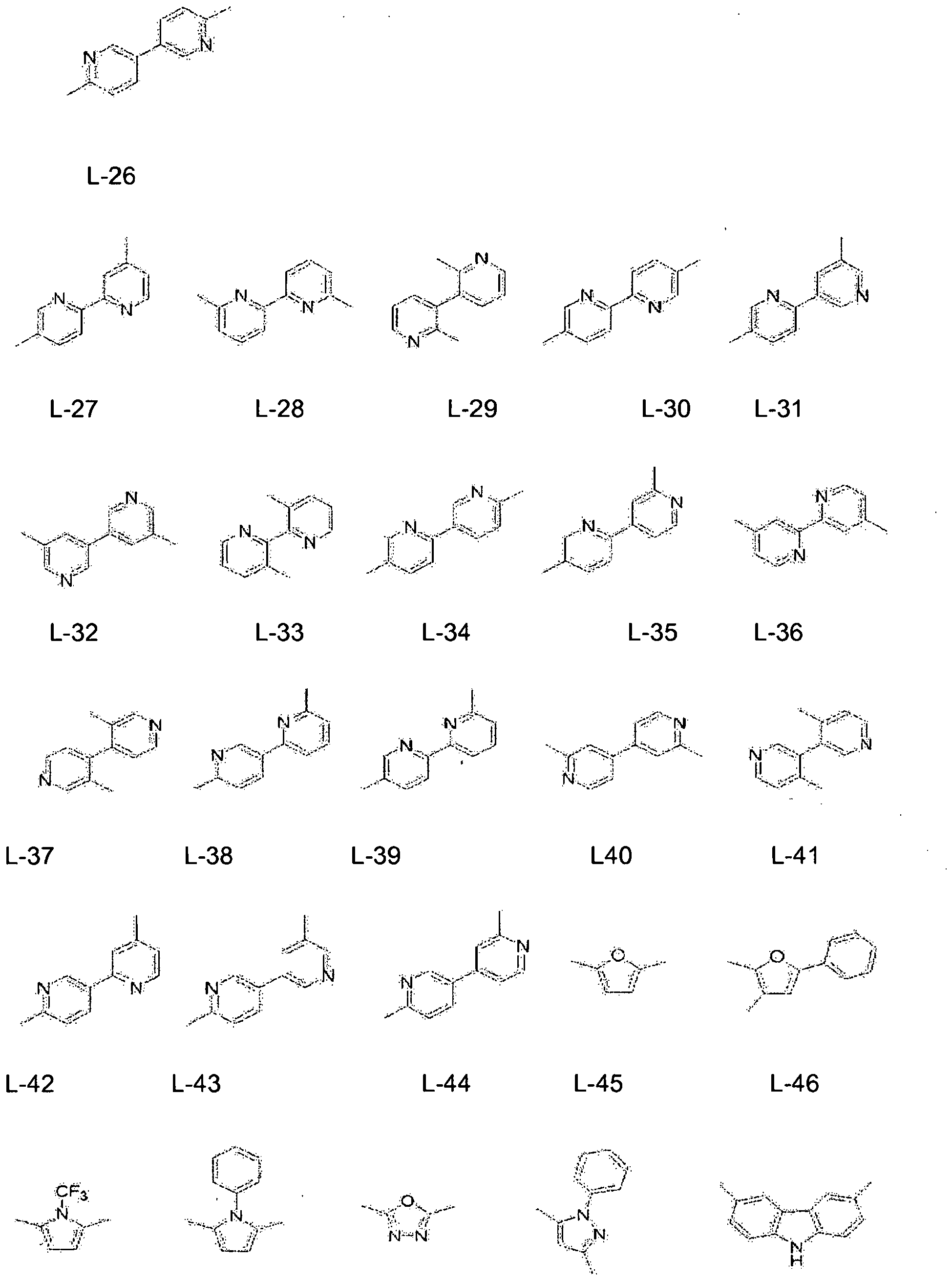

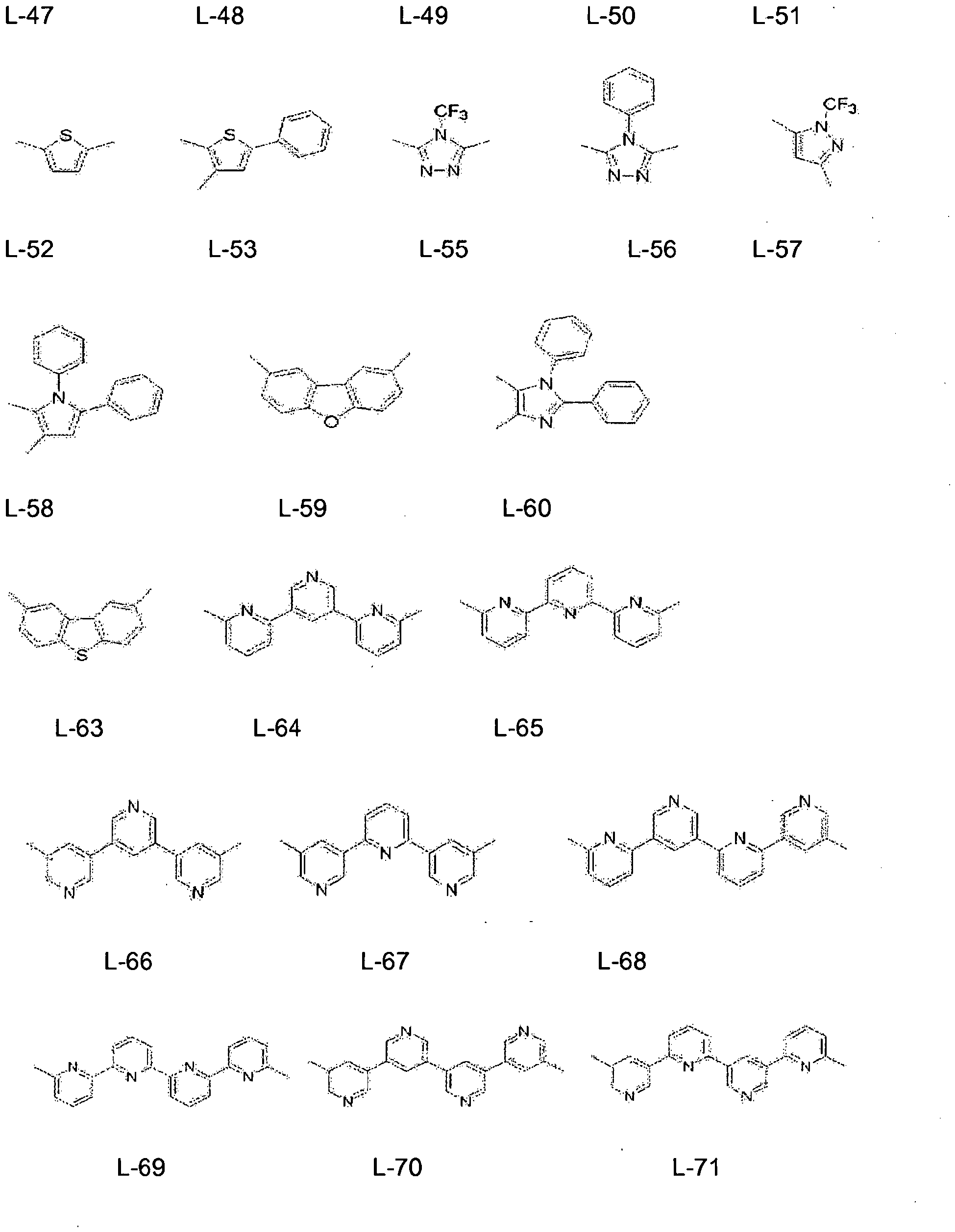

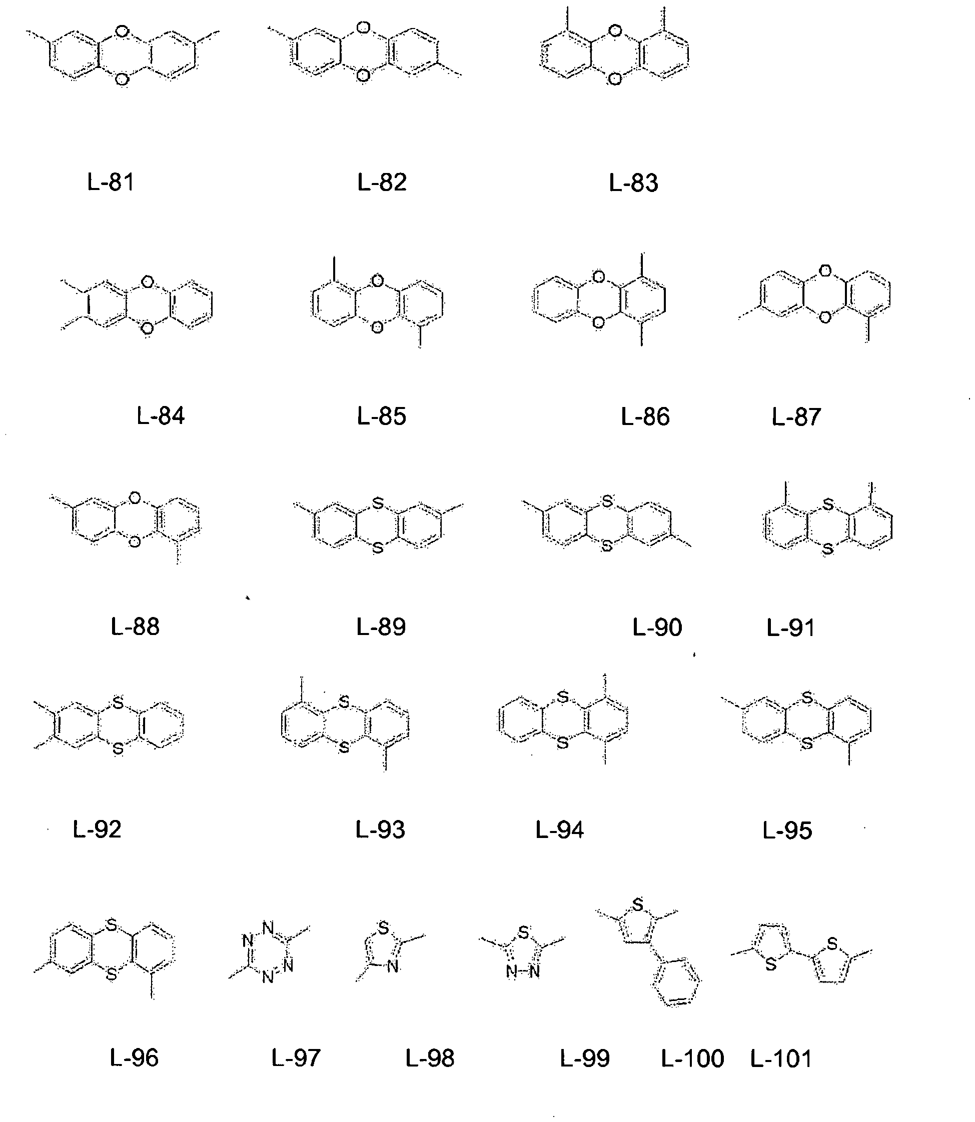

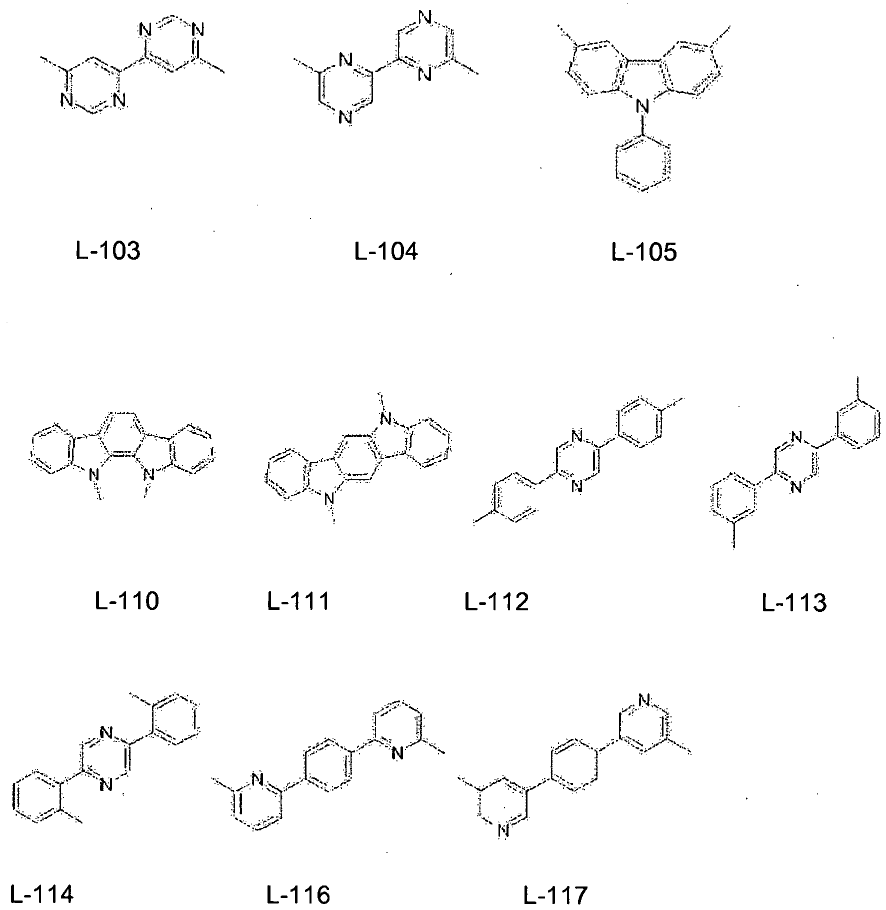

6. The compound for an organic photoelectric device of claim 1, wherein the compound for an organic photoelectric device is represented by the following Chemical Formula 3 to Chemical Formula 8: 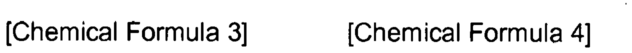 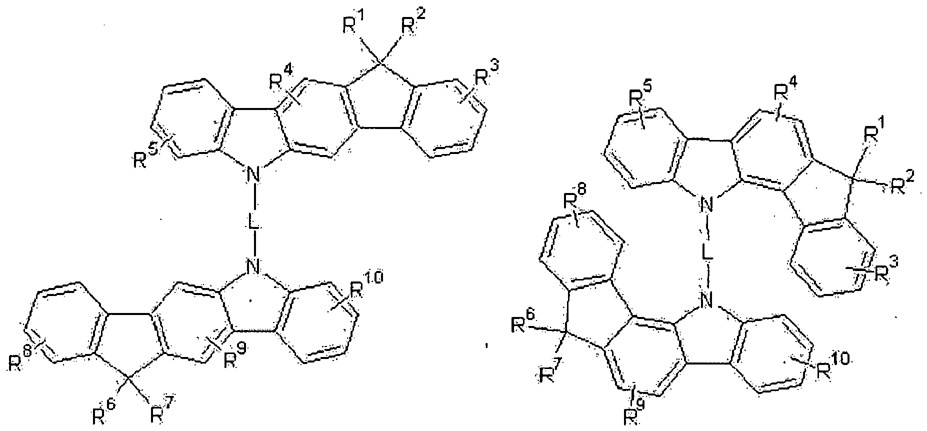 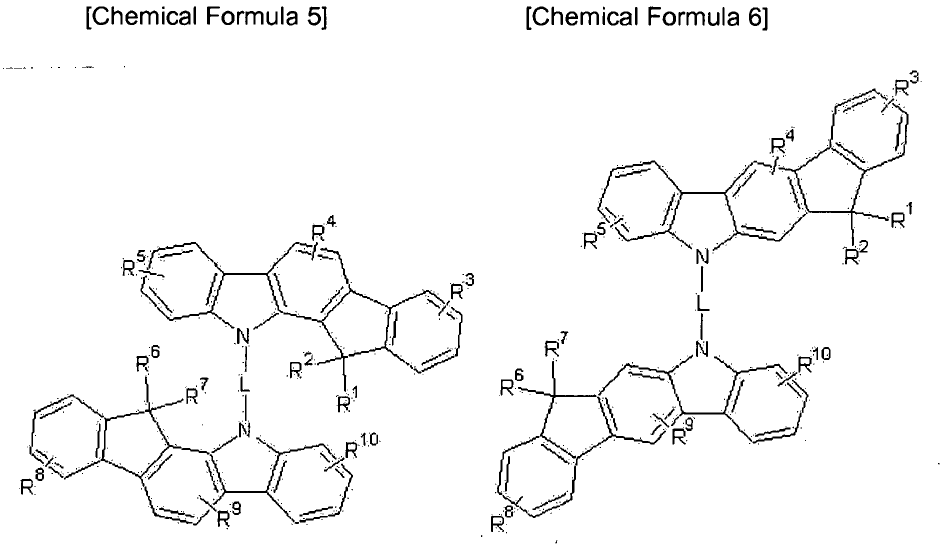 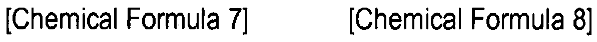 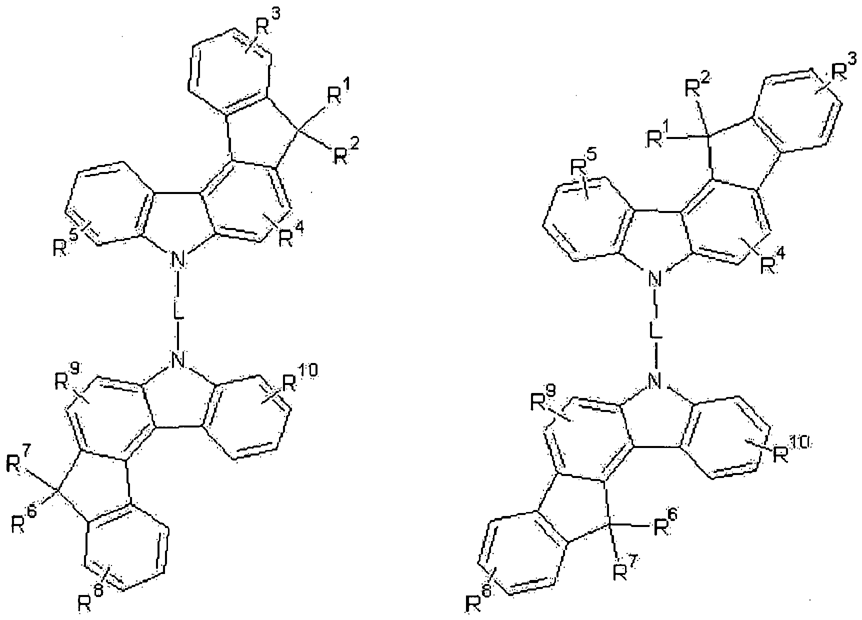 wherein, in Chemical Formulas 3 to 8,
L is a divalent linking group that is a substituted or unsubstituted C2 to C30 heteroarylene group
R¹, R⁶ are phenyl-Ra¹,
R², R⁷ are phenyl-Ra², and
R³ to R⁵, and R⁸ to R¹⁰ are the same or different, and are each independently hydrogen, a carbazolyl group, a C1 to C30 alkyl group, a C6 to C30 aryl group, a C2 to C30 heteroaryl group, a C6 to C30 arylamine group, or a combination thereof.

7. The compound for an organic photoelectric device of claim 1, wherein the compound for an organic photoelectric device is represented by the following Chemical Formulas 9 to 21, and 29 to 32:

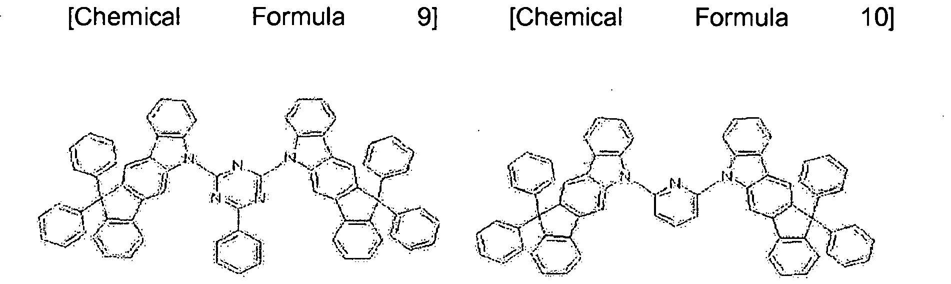

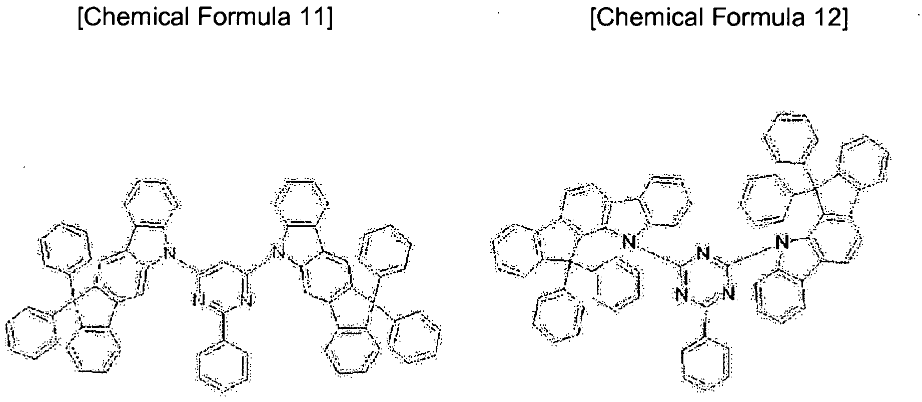

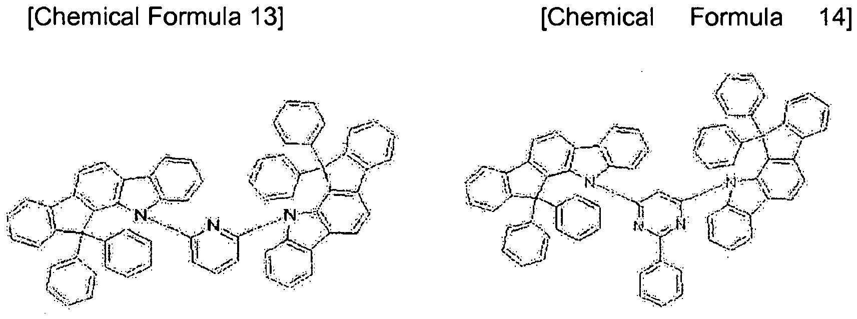

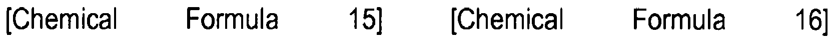

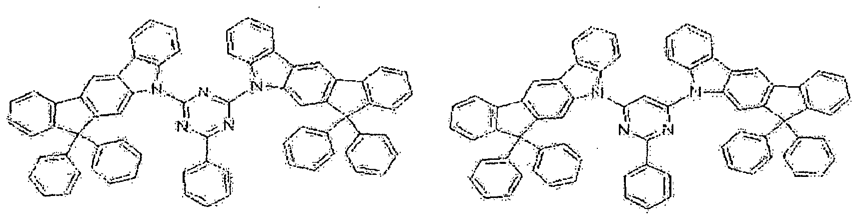

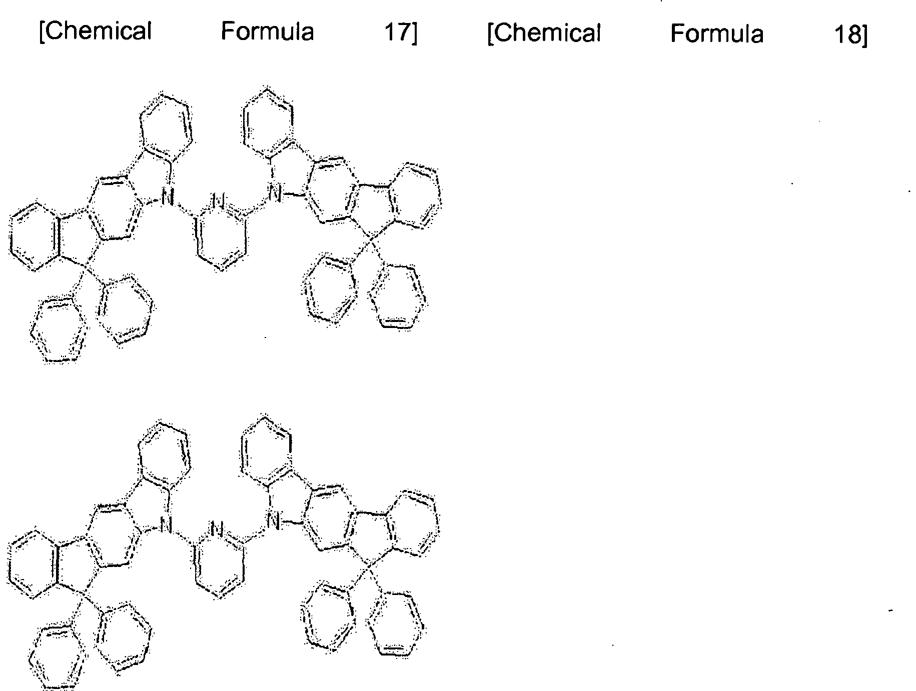

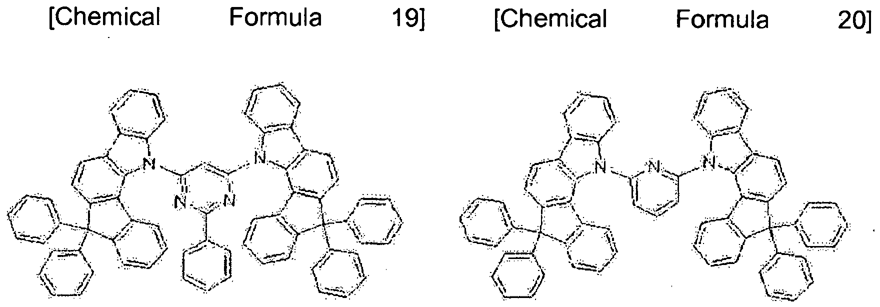

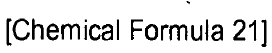

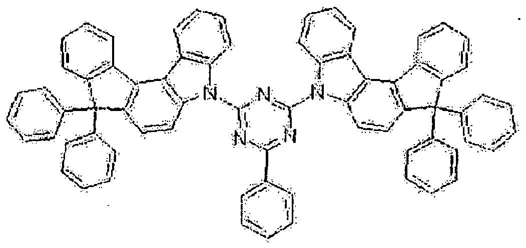

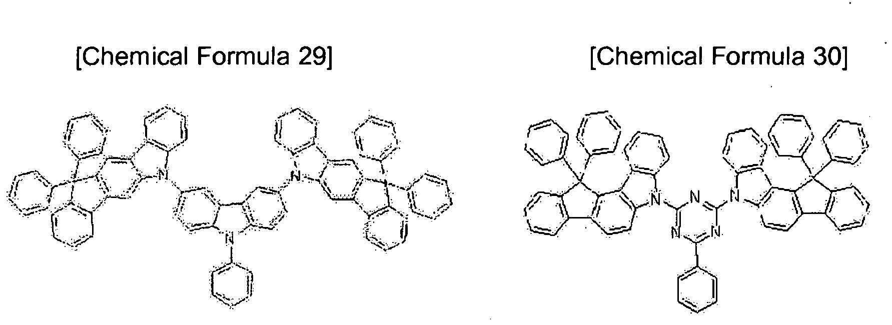

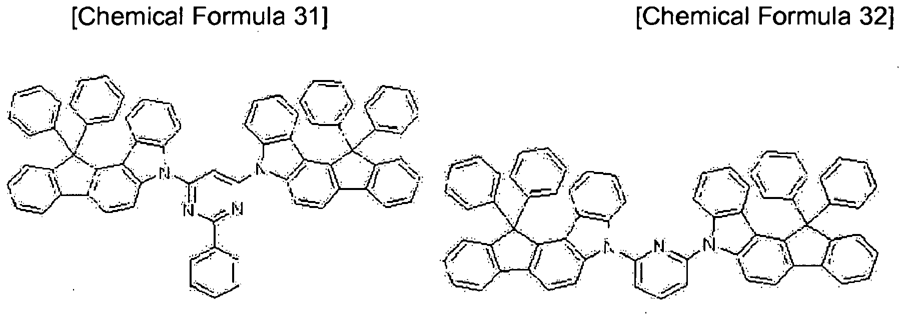

8. The compound for an organic photoelectric device of claim 1, wherein the compound for an organic photoelectric device is used as a charge transport material or a host material.

9. The compound for an organic photoelectric device of claim 1, wherein the compound for an organic photoelectric device has a thermal decomposition temperature (Td) of 350 to 600 °C.

10. An organic light emitting diode comprising
an anode, a cathode, and at least one organic thin layer interposed between the anode and cathode,
wherein at least one organic thin layer includes the compound for an organic photoelectric device according to one of claims 1 to 9.

11. The organic light emitting diode of claim 10, wherein the organic thin layer is an emission layer, a hole blocking layer, an electron transport layer (ETL), an electron injection layer (EIL), a hole injection layer (HIL), a hole transport layer (HTL), an electron blocking layer, or a combination thereof.

12. A display device comprising the organic light emitting diode according to claim 10.

## Patentansprüche

1. Verbindung für eine organische photoelektrische Einheit, umfassend Substituenten, die durch die nachstehenden chemischen Formeln 1a und 2 dargestellt werden: 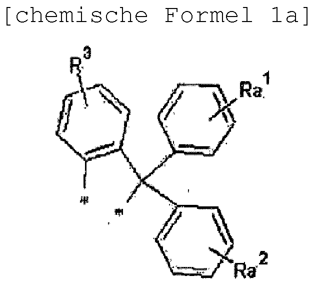 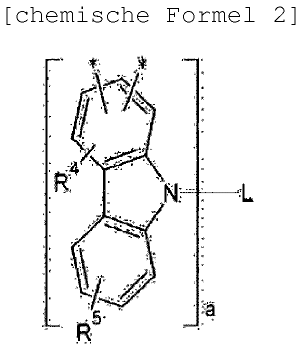 wobei in den chemischen Formeln 1a und 2 L eine zweiwertige Kopplungsgruppe ist, die eine substituierte oder nichtsubstituierte C2- bis C30-Heteroarylengruppe ist,
Ra¹ und Ra² gleich oder verschieden sind und jeweils unabhängig Wasserstoff oder eine C1- bis C10-Alkylgruppe sind und
R³ Wasserstoff, eine Carbazolylgruppe, eine C1- bis C30-Alkylgruppe, eine C6- bis C30-Arylgruppe, eine C2- bis C30-Heteroarylgruppe, eine C6- bis C30-Arylamingruppe oder eine Kombination davon ist,
R⁴ und R⁵ gleich oder verschieden sind und jeweils unabhängig Wasserstoff, eine Carbazolylgruppe, eine C1- bis C30-Alkylgruppe, eine C6- bis C30-Arylgruppe, eine C2- bis C30-Heteroarylgruppe, eine C6- bis C30-Arylamingruppe oder eine Kombination davon sind und
a eine ganze Zahl von 2 ist.

2. Verbindung für eine organische photoelektrische Einheit gemäß Anspruch 1, wobei R³ bis R⁵ in den chemischen Formeln 1a und 2 gleich oder verschieden sind und jeweils unabhängig Wasserstoff, eine C1- bis C30-Alkylgruppe, eine C6- bis C30-Arylgruppe oder eine Kombination davon sind.

3. Verbindung für eine organische photoelektrische Einheit gemäß Anspruch 1, wobei die vorstehende chemische Formel 2 durch eine der nachstehenden chemischen Formeln 2a bis 2c dargestellt wird: 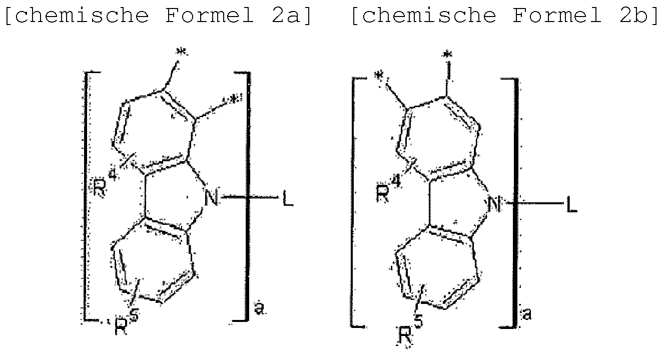 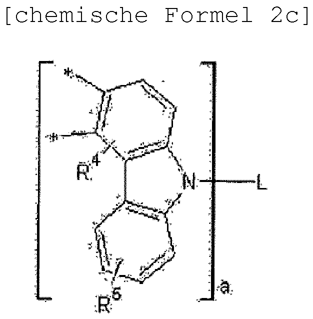 wobei in den chemischen Formeln 2a bis 2c
L eine zweiwertige Kopplungsgruppe ist, die eine substituierte oder nichtsubstituierte C2- bis C30-Heteroarylengruppe ist,
R⁴ und R⁵ gleich oder verschieden sind und jeweils unabhängig Wasserstoff, eine Carbazolylgruppe, eine C1- bis C30-Alkylgruppe, eine C6- bis C30-Arylgruppe, eine C2- bis C30-Heteroarylgruppe, eine C6- bis C30-Arylamingruppe oder eine Kombination davon sind und
a eine ganze Zahl von 2 ist.

4. Verbindung für eine organische photoelektrische Einheit gemäß Anspruch 1, wobei das L in der vorstehenden chemischen Formel 2 eine zweiwertige Kopplungsgruppe ist, die von Verbindungen abgeleitet ist, die von den nachstehenden chemischen Formeln 2d bis 2g, 2i und 2j dargestellt werden, oder eine Kombination davon: 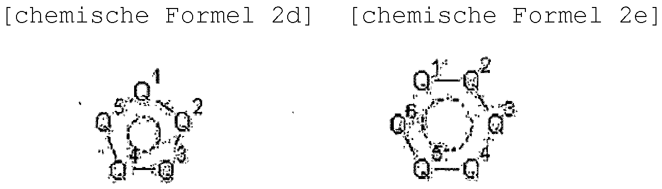 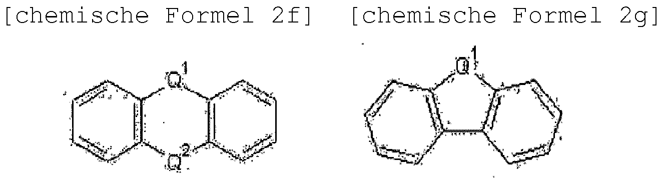 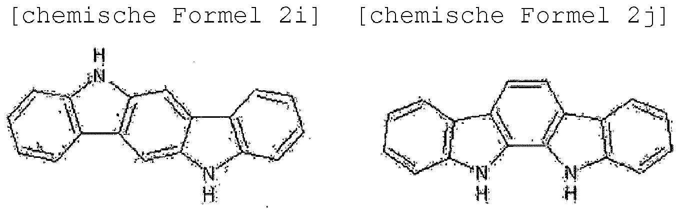 wobei in den chemischen Formeln 2d bis 2g, 2i und 2j
Q¹ bis Q⁶ gleich oder verschieden sind und jeweils unabhängig ein substituiertes oder nichtsubstituiertes N-Atom, ein substituiertes oder nichtsubstituiertes P-Atom, ein substituiertes oder nichtsubstituiertes S-Atom, ein substituiertes oder nichtsubstituiertes O-Atom, ein substituiertes oder nichtsubstituiertes C-Atom oder eine Kombination davon sind, wobei sich das "substituiert" auf eine Substitution mit Wasserstoff, einer Oxidgruppe, einer Cyanogruppe, einer Halogengruppe, einer C1- bis C30-Alkylgruppe, einer C6- bis C30-Arylgruppe, einer C2- bis C30-Heteroarylgruppe oder einer Kombination davon bezieht.

5. Verbindung für eine organische photoelektrische Einheit gemäß Anspruch 1, wobei L in der vorstehenden chemischen Formel 2 von der nachstehenden chemischen Formel 2k dargestellt wird:

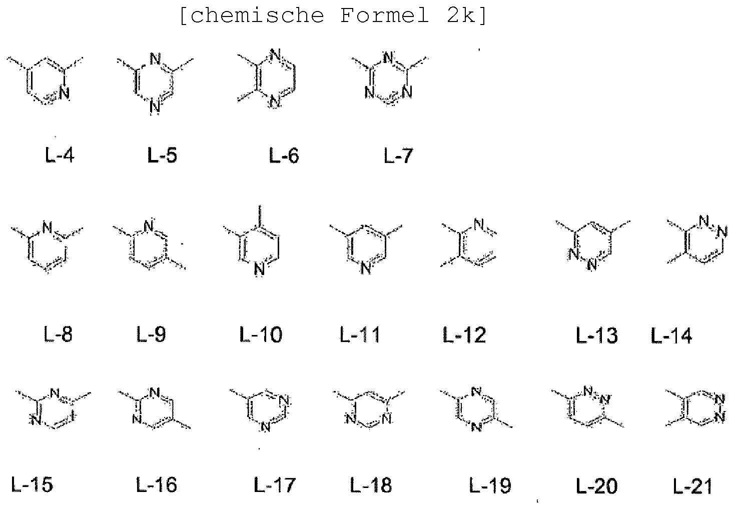

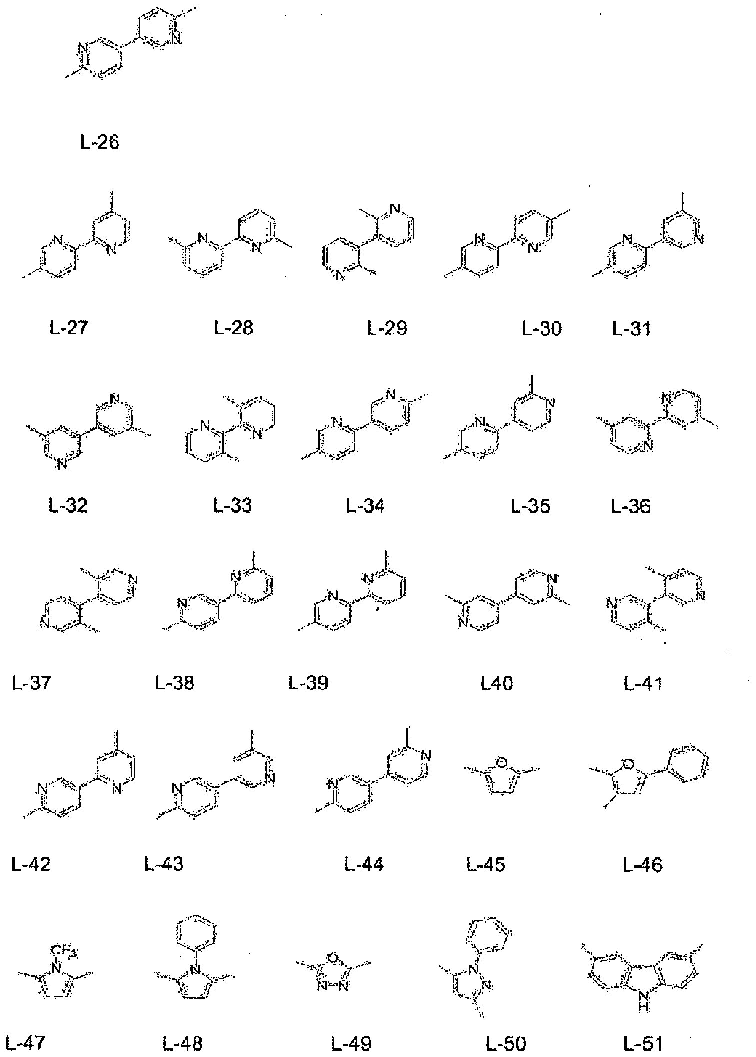

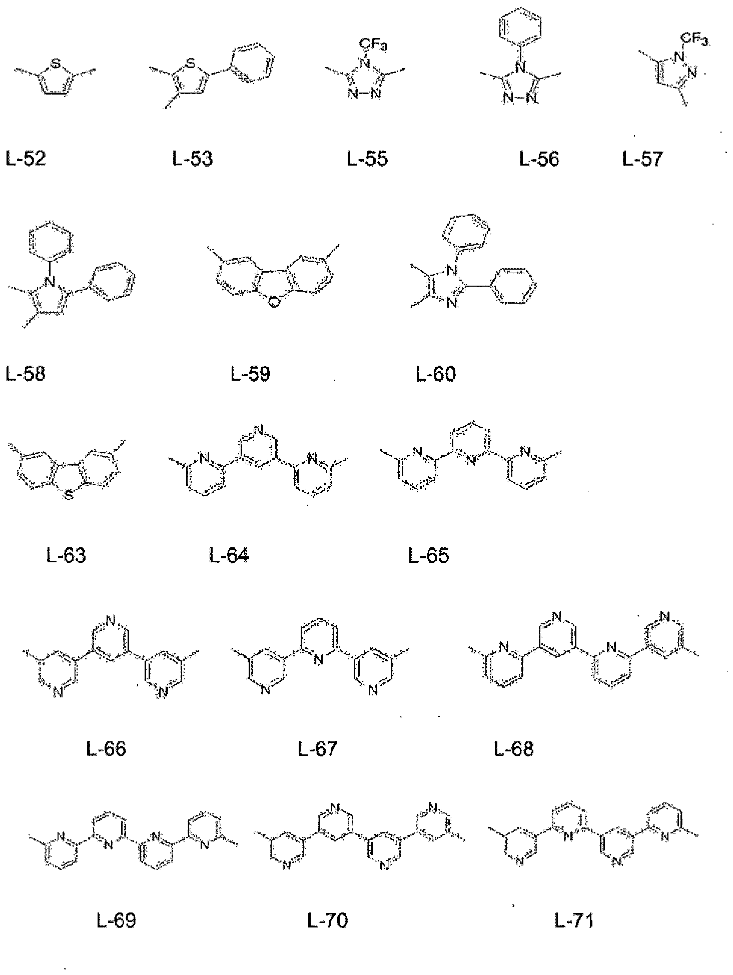

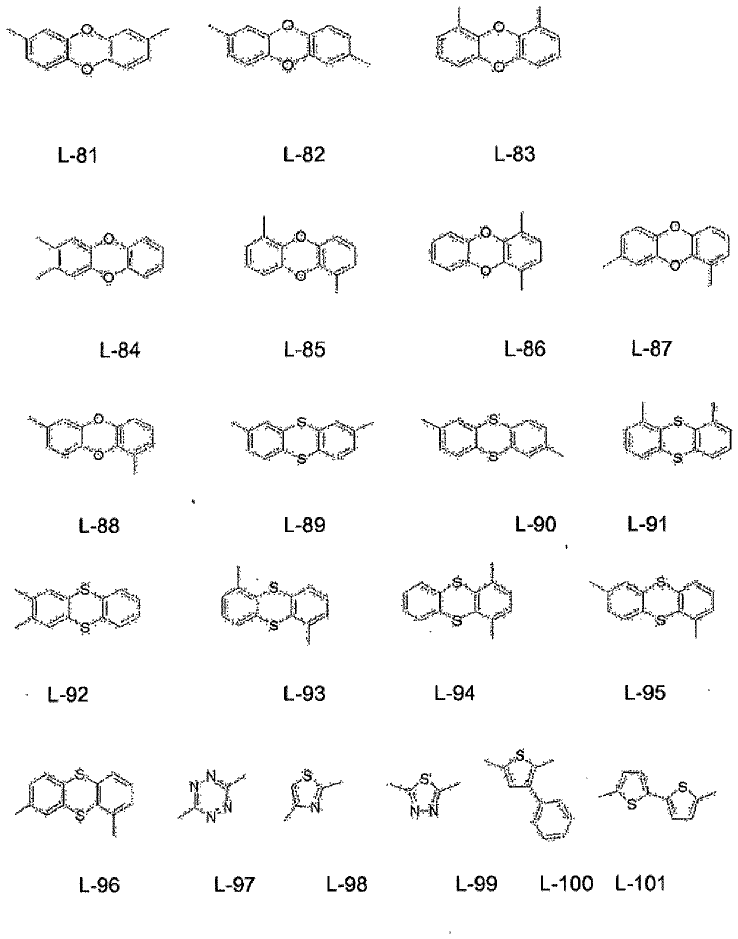

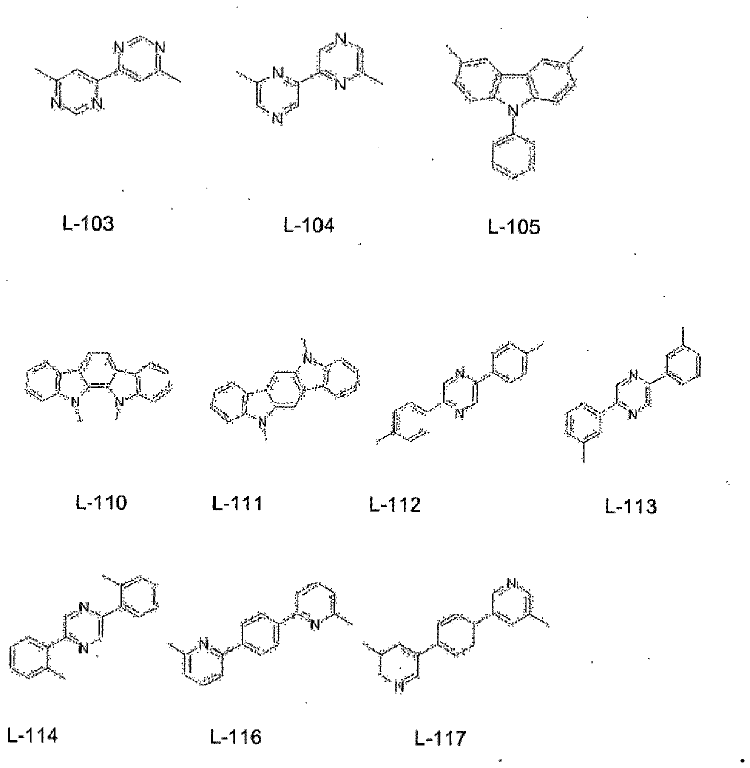

6. Verbindung für eine organische photoelektrische Einheit gemäß Anspruch 1, wobei die Verbindung für eine organische photoelektrische Einheit durch die nachstehende chemische Formel 3 bis chemische Formel 8 dargestellt wird: 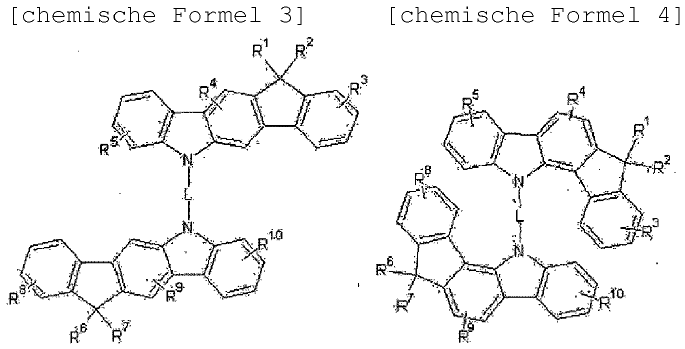 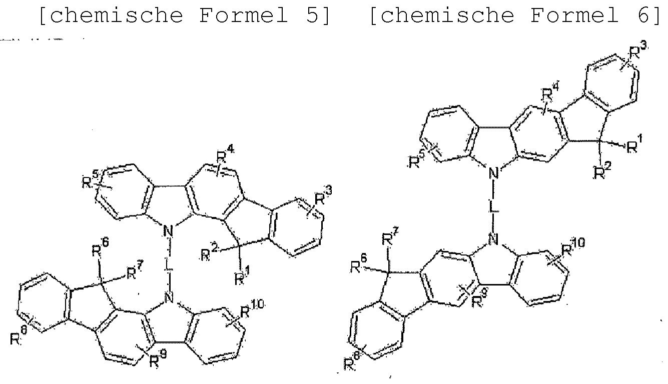 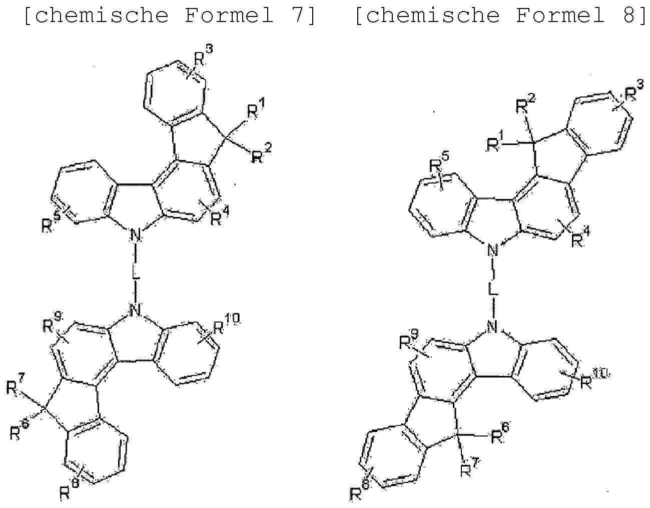 wobei in den chemischen Formeln 3 bis 8
L eine zweiwertige Kopplungsgruppe ist, die eine substituierte oder nichtsubstituierte C2- bis C30-Heteroarylengruppe ist,
R¹, R⁶ Phenyl-Ra¹ sind,
R², R⁷ Phenyl-Ra² sind und
R³ bis R⁵ und R⁸ bis R¹⁰ gleich oder verschieden sind und jeweils unabhängig Wasserstoff, eine Carbazolylgruppe, eine C1- bis C30-Alkylgruppe, eine C6- bis C30-Arylgruppe, eine C2- bis C30-Heteroarylgruppe, eine C6- bis C30-Arylamingruppe oder eine Kombination davon sind.

7. Verbindung für eine organische photoelektrische Einheit gemäß Anspruch 1, wobei die Verbindung für eine organische photoelektrische Einheit durch die nachstehenden chemischen Formeln 9 bis 21 und 29 bis 32 dargestellt wird:

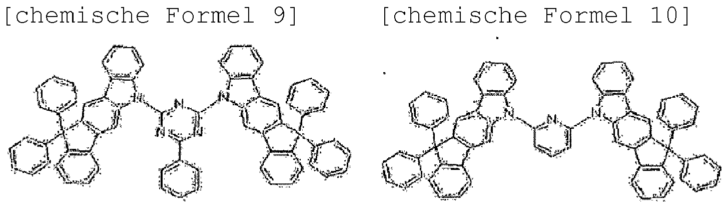

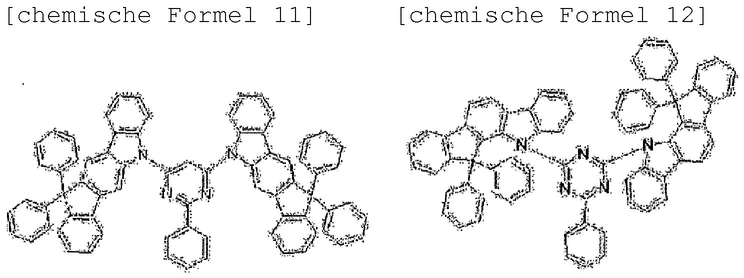

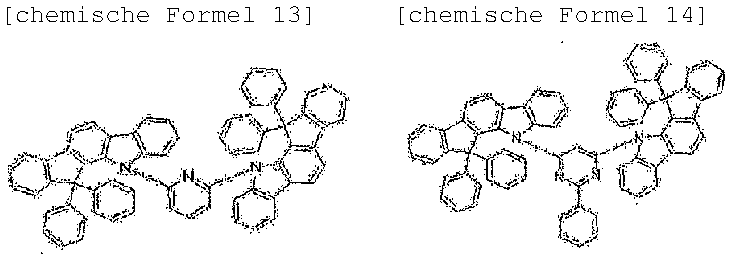

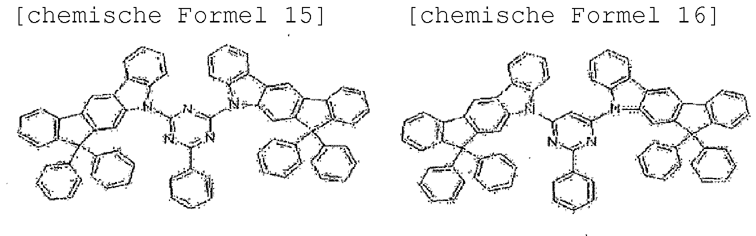

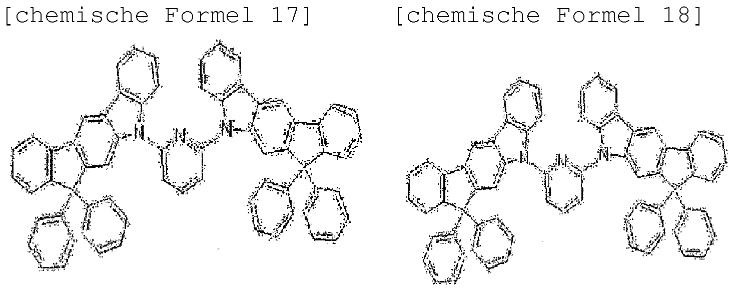

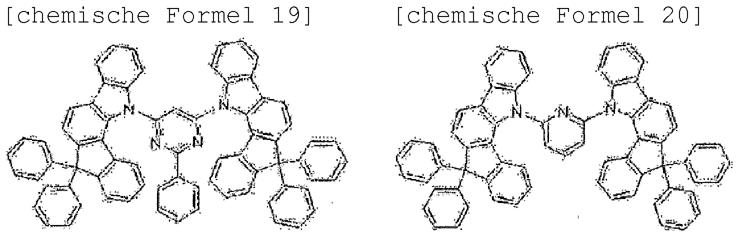

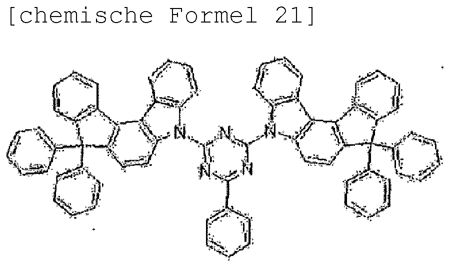

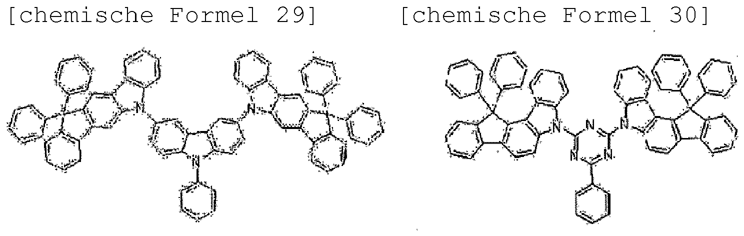

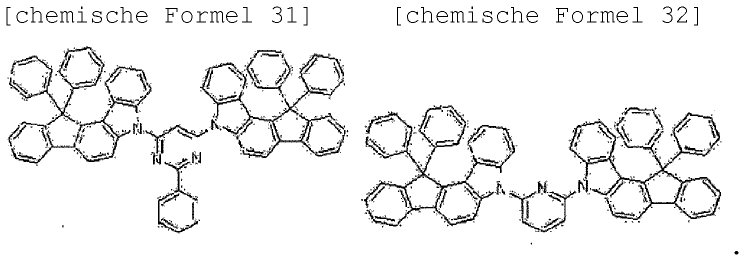

8. Verbindung für eine organische photoelektrische Einheit gemäß Anspruch 1, wobei die Verbindung für eine organische photoelektrische Einheit als Ladungstransportmaterial oder als Wirtsmaterial verwendet wird.

9. Verbindung für eine organische photoelektrische Einheit gemäß Anspruch 1, wobei die Verbindung für eine organische photoelektrische Einheit eine Wärmezersetzungstemperatur (Td) von 350 bis 600 °C aufweist.

10. Organische lichtemittierende Diode, umfassend
eine Anode, eine Kathode und wenigstens eine organische Dünnschicht, die zwischen der Anode und der Kathode angeordnet ist,
wobei wenigstens eine organische Dünnschicht die Verbindung für eine organische photoelektrische Einheit gemäß einem der Ansprüche 1 bis 9 enthält.

11. Organische lichtemittierende Diode gemäß Anspruch 10, wobei die organische Dünnschicht eine Emissionsschicht, eine Lochblockierungsschicht, eine Elektronentransportschicht (ETL), eine Elektroneninjektionsschicht (EIL), eine Lochinjektionsschicht (HIL), eine Lochtransportschicht (HTL), eine Elektronenblockierungsschicht oder eine Kombination davon ist.

12. Anzeigeeinheit, umfassend die organische lichtemittierende Diode gemäß Anspruch 10.

## Revendications

1. Composé pour un dispositif photoélectrique organique comprenant des substituants représentés par les formules chimiques 1a et 2 suivantes : 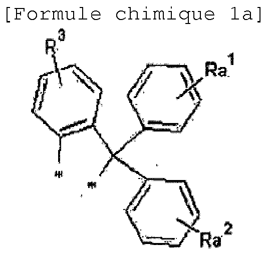 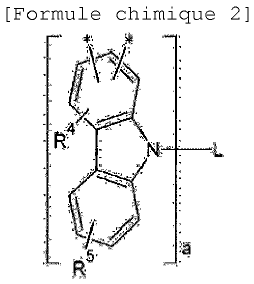 dans lequel, dans les formules chimiques 1a et 2,
L représente un groupe de liaison divalent qui est un groupe hétéroarylène en C2 à C30 substitué ou non substitué,
Ra¹ et Ra² sont identiques ou différents, et représentent chacun indépendamment un hydrogène ou un groupe alkyle en C1 à C10, et
R³ représente un hydrogène, un groupe carbazolyle, un groupe alkyle en C1 à C30, un groupe aryle en C6 à C30, un groupe hétéroaryle en C2 à C30, un groupe arylamino en C6 à C30, ou une combinaison de ceux-ci,
R⁴ et R⁵ sont identiques ou différents et représentent chacun indépendamment un hydrogène, un groupe carbazolyle, un groupe alkyle en C1 à C30, un groupe aryle en C6 à C30, un groupe hétéroaryle en C2 à C30, un groupe arylamino en C6 à C30, ou une combinaison de ceux-ci, et
a est un entier valant 2.

2. Composé pour un dispositif photoélectrique organique selon la revendication 1, dans lequel R³ à R⁵ dans les formules chimiques 1a et 2 sont identiques ou différents, et représentent chacun indépendamment un hydrogène, un groupe alkyle en C1 à C30, un groupe aryle en C6 à C30, ou une combinaison de ceux-ci.

3. Composé pour un dispositif photoélectrique organique selon la revendication 1, la formule chimique 2 ci-dessus étant représentée par une des formules chimiques 2a à 2c suivantes : 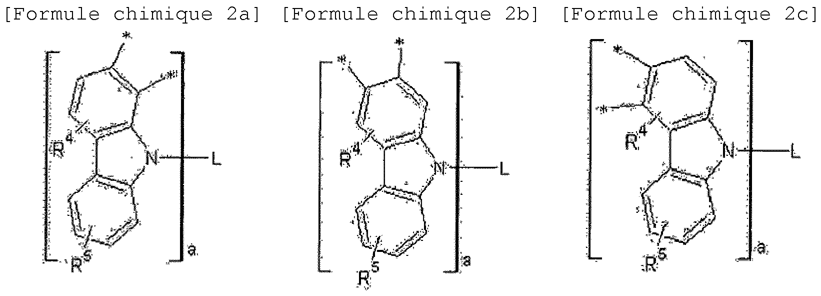 dans lequel, dans les formules chimiques 2a à 2c,
L représente un groupe de liaison divalent qui est un groupe hétéroarylène en C2 à C30 substitué ou non substitué,
R⁴ et R⁵ sont identiques ou différents et représentent chacun indépendamment un hydrogène, un groupe carbazolyle, un groupe alkyle en C1 à C30, un groupe aryle en C6 à C30, un groupe hétéroaryle en C2 à C30, un groupe arylamino en C6 à C30, ou une combinaison de ceux-ci, et
a est un entier valant 2.

4. Composé pour un dispositif photoélectrique organique selon la revendication 1, dans lequel le L de la formule chimique 2 ci-dessus représente un groupe de liaison divalent dérivé de composés représentés par les formules chimiques 2d à 2g, 2i et 2j suivantes ou une combinaison de celles-ci : 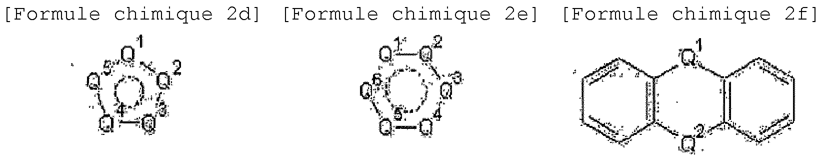 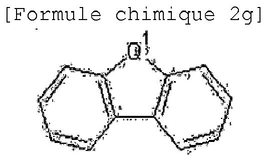 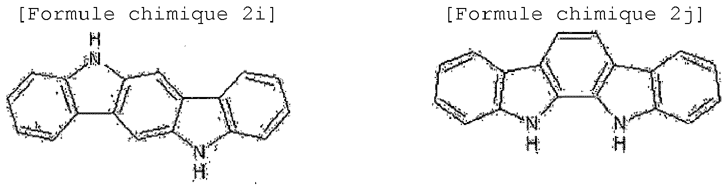 dans lequel, dans les formules chimiques 2d à 2g, 2i et 2j,
Q¹ à Q⁶ sont identiques ou différents, et représentent chacun indépendamment un atome N substitué ou non substitué, un atome P substitué ou non substitué, un atome S substitué ou non substitué, un atome O substitué ou non substitué, un atome C substitué ou non substitué, ou une combinaison de ceux-ci, « substitué » signifiant substitué par un hydrogène, un groupe oxyde, un groupe cyano, un groupe halogéno, un groupe alkyle en C1 à C30, un groupe aryle en C6 à C30, un groupe hétéroaryle en C2 à C30, ou une combinaison de ceux-ci.

5. Composé pour un dispositif photoélectrique organique selon la revendication 1, dans lequel le L de la formule chimique 2 ci-dessus est représenté par la formule chimique 2k suivants :

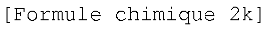

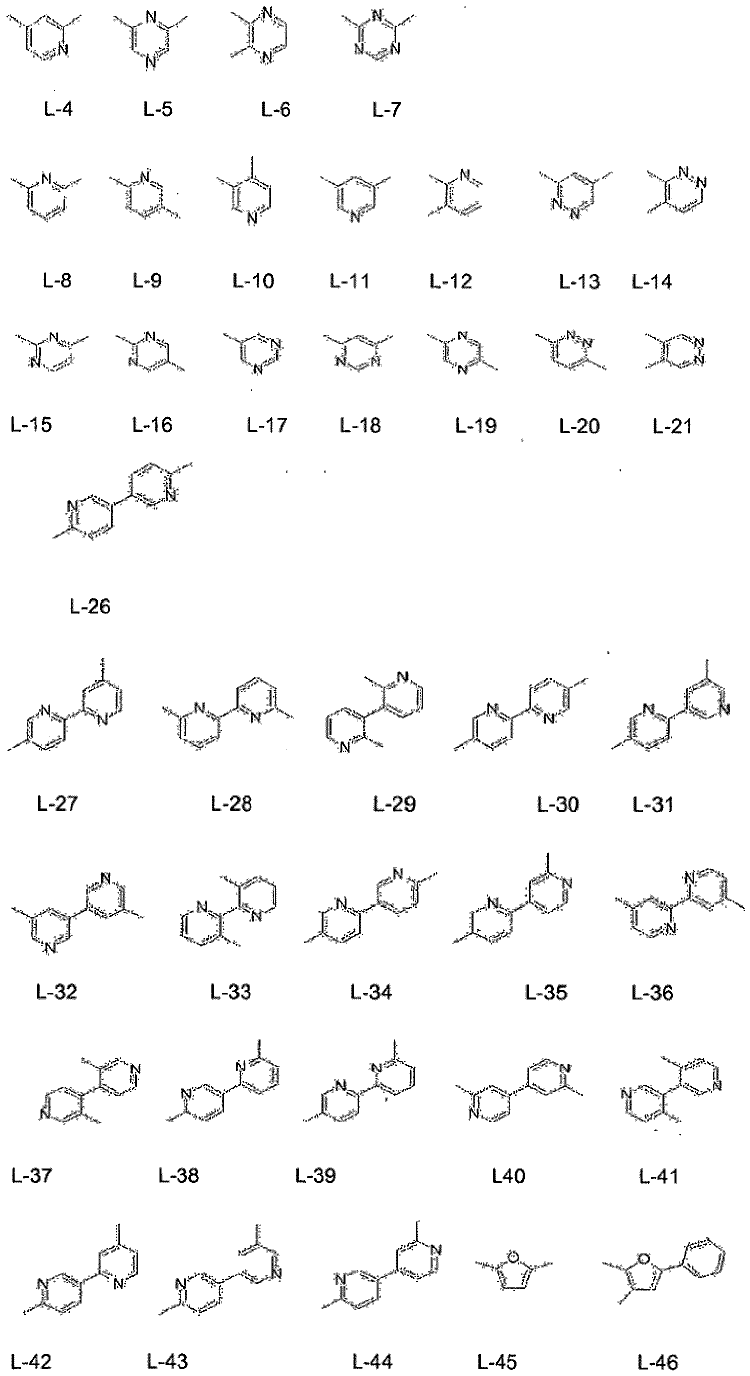

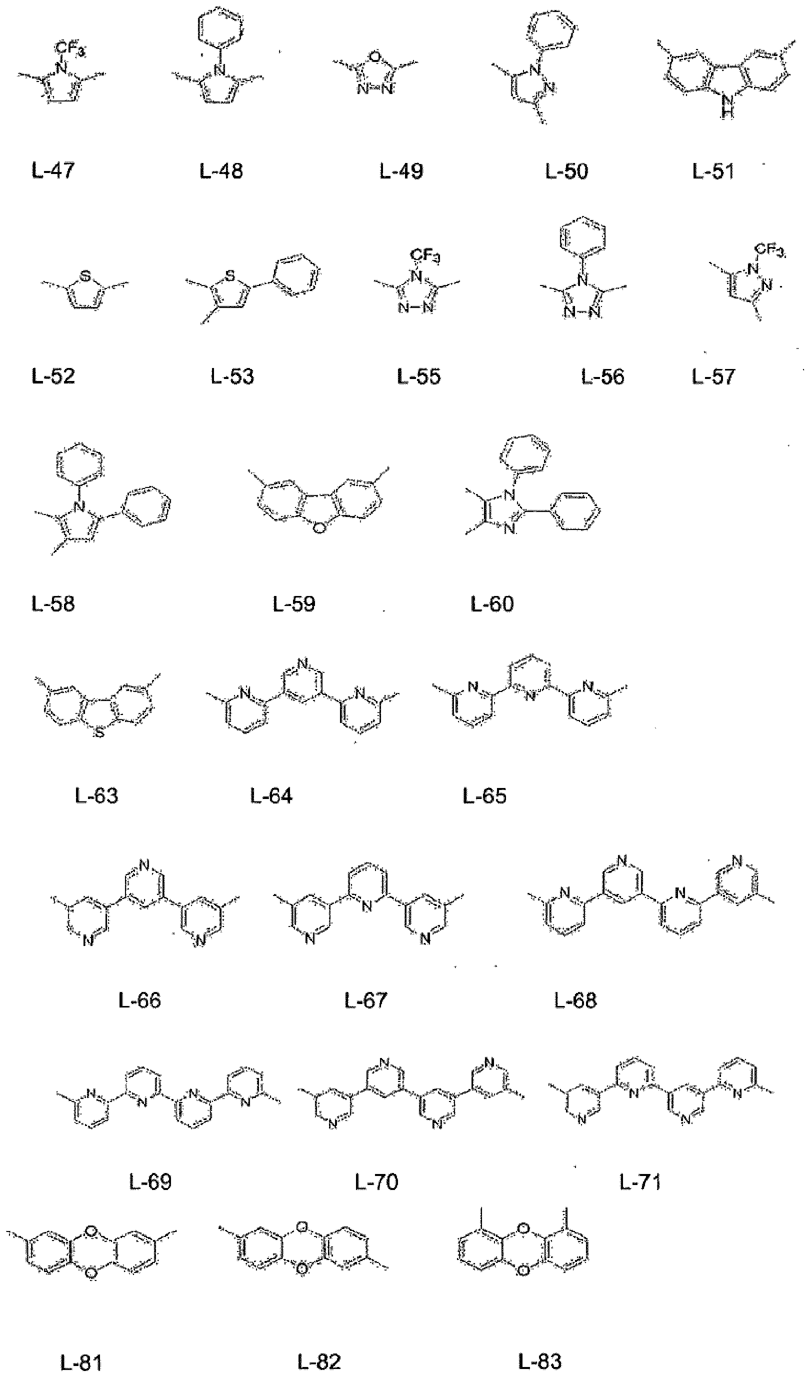

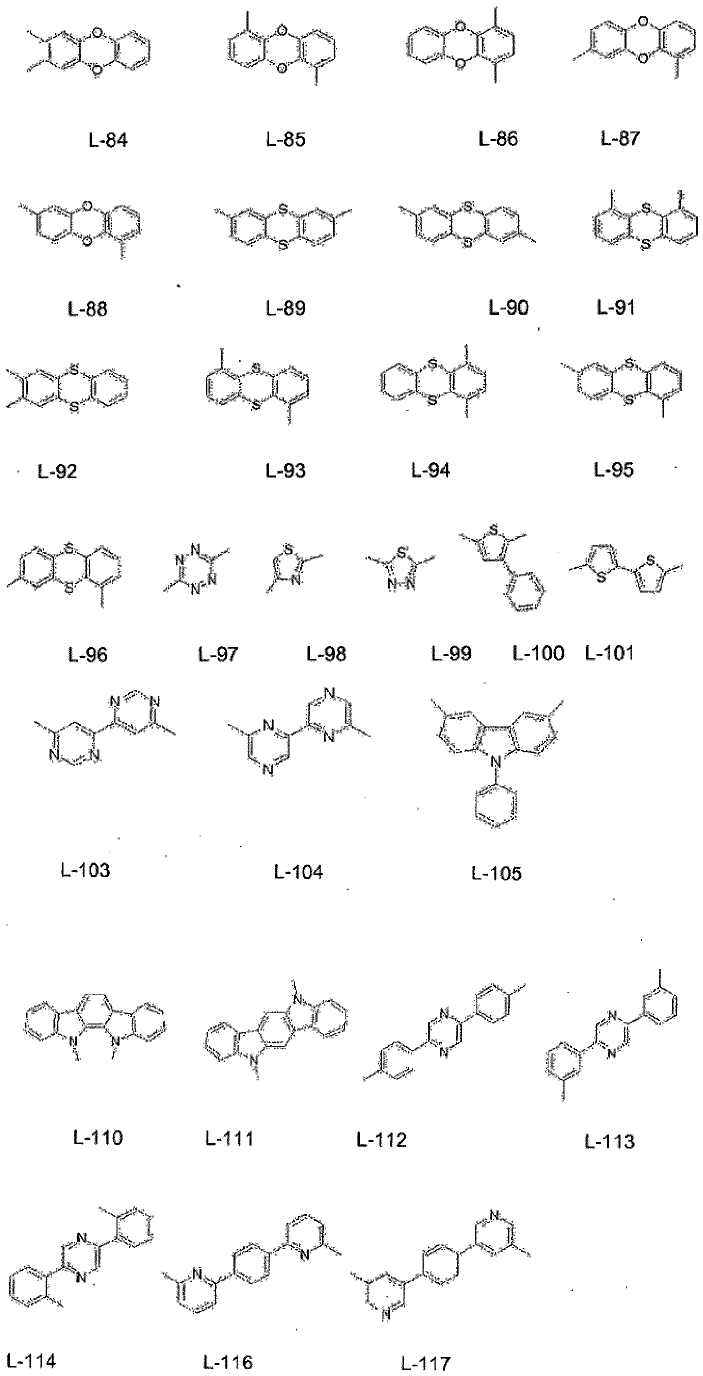

6. Composé pour un dispositif photoélectrique organique selon la revendication 1, le composé pour un dispositif photoélectrique organique étant représenté par la formule chimique 3 à la formule chimique 8 suivantes : 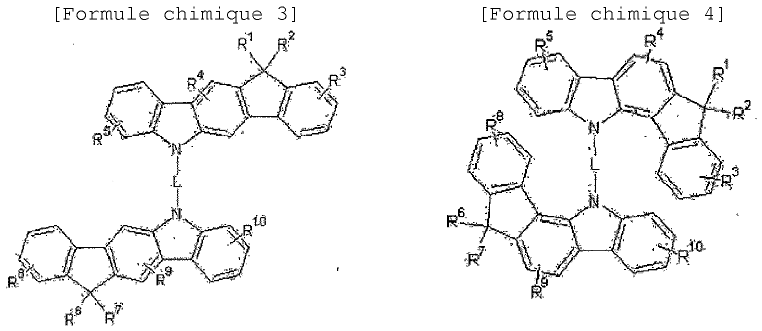 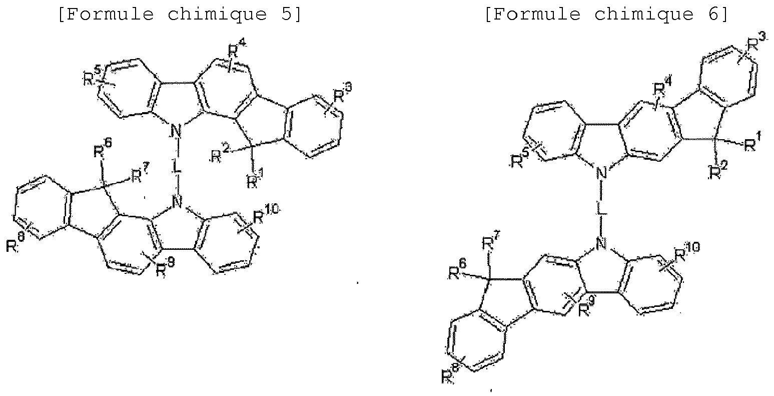 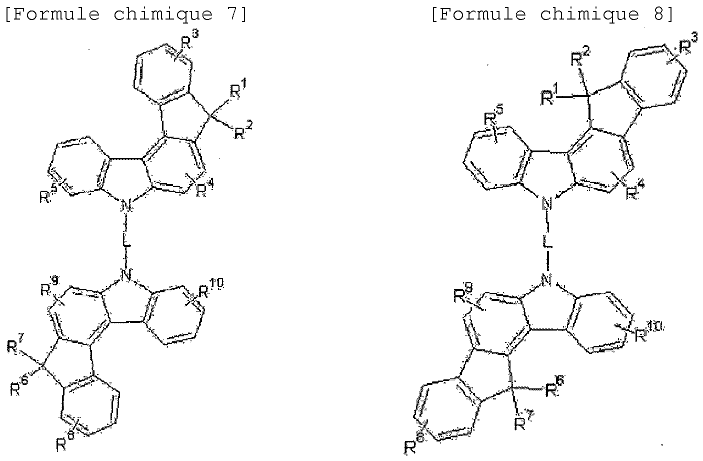 dans lequel, dans les formules chimiques 3 à 8,
L représente un groupe de liaison divalent qui est un groupe hétéroarylène en C2 à C30 substitué ou non substitué,
R¹ et R⁶ représentent un groupe phényl-Ra¹,
R² et R⁷ représentent un groupe phényl-Ra², et
R³ à R⁵ et R⁸ à R¹⁰ sont identiques ou différents, et représentent chacun indépendamment un hydrogène, un groupe carbazolyle, un groupe alkyle en C1 à C30, un groupe aryle en C6 à C30, un groupe hétéroaryle en C2 à C30, un groupe arylamino en C6 à C30, ou une combinaison de ceux-ci.

7. Composé pour un dispositif photoélectrique organique selon la revendication 1, le composé pour un dispositif photoélectrique organique étant représenté par les formules chimiques 9 à 21 et 29 à 32 suivantes :

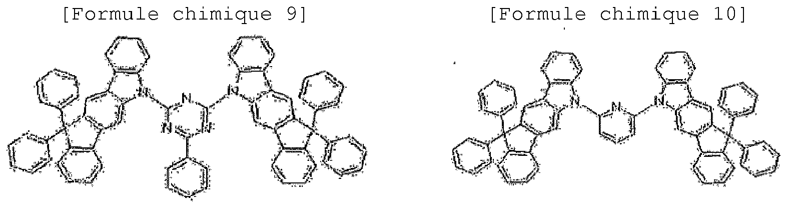

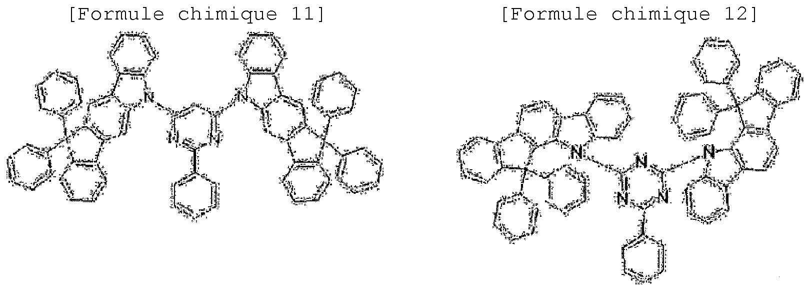

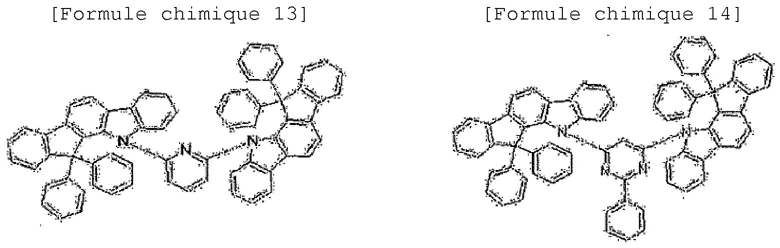

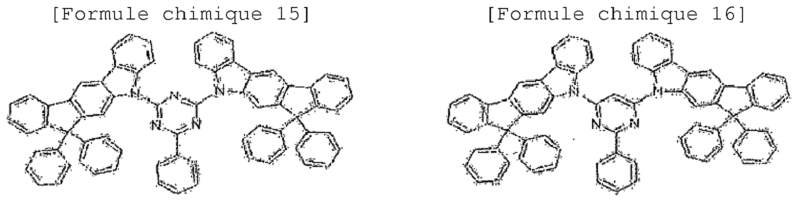

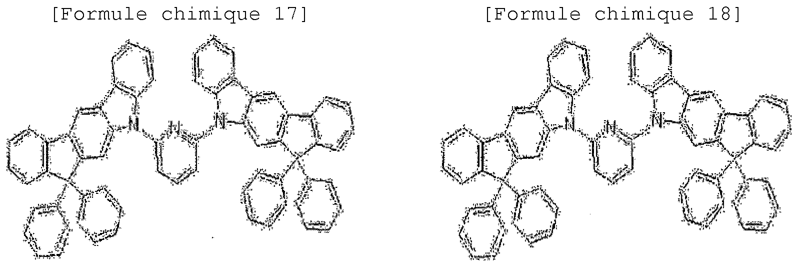

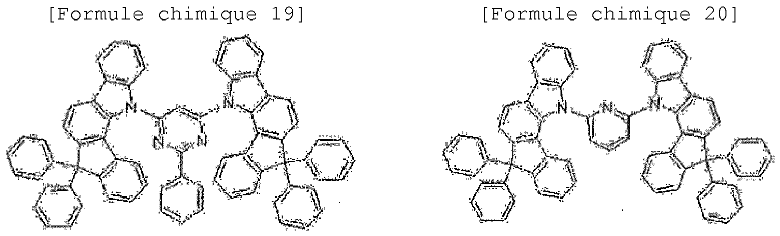

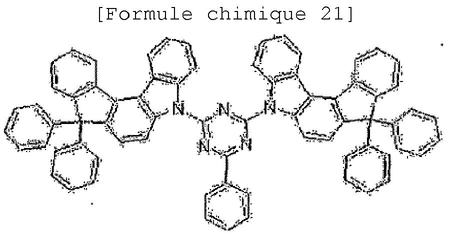

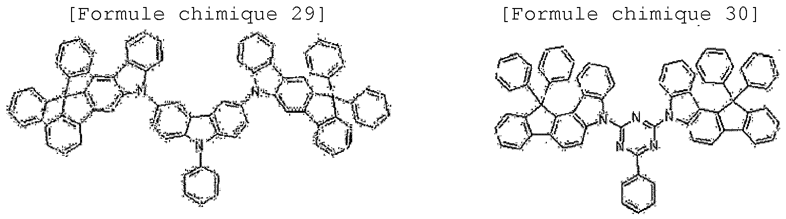

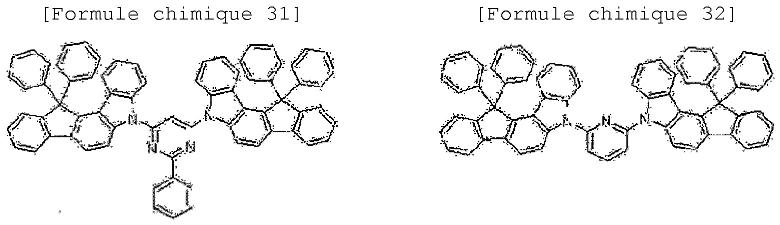

8. Composé pour un dispositif photoélectrique organique selon la revendication 1, le composé pour un dispositif photoélectrique organique étant utilisé comme matériau de transport de charges ou matériau hôte.

9. Composé pour un dispositif photoélectrique organique selon la revendication 1, le composé pour un dispositif photoélectrique organique ayant une température de décomposition thermique (Td) de 350 à 600 °C.

10. Diode électroluminescente organique comprenant
une anode, une cathode, et au moins une couche mince organique intercalée entre l'anode et la cathode,
dans laquelle au moins une couche mince organique comporte le composé pour un dispositif photoélectrique organique selon une des revendications 1 à 9.

11. Diode électroluminescente organique selon la revendication 10, dans laquelle la couche mince organique est une couche d'émission, une couche de blocage de trous, une couche de transport d'électrons (ETL), une couche d'injection d'électrons (EIL), une couche d'injection de trous (HIL), une couche de transport de trous (HTL), une couche de blocage d'électrons, ou une combinaison de celles-ci.

12. Dispositif d'affichage comprenant la diode électroluminescente organique selon la revendication 10.
